# EUROPEAN PATENT SPECIFICATION

(11) **EP 4 404 262 B1**
(45) Date of publication and mention of the grant of the patent: **06.05.2026**
(21) Application number: 23220525.2
(22) Date of filing: 28.12.2023
(51) Int. Cl.: H10D 8/80, H10D 18/00, H10D 89/60

(54) **DEVICE FOR ELECTROSTATIC DISCHARGE PROTECTION USING SILICON CONTROLLED RECTIFIER**
VORRICHTUNG ZUM SCHUTZ VOR ELEKTROSTATISCHER ENTLADUNG MIT EINEM SILICIUMGESTEUERTEN GLEICHRICHTER
DISPOSITIF DE PROTECTION CONTRE LES DÉCHARGES ÉLECTROSTATIQUES UTILISANT UN REDRESSEUR COMMANDÉ AU SILICIUM

(30) Priority: 04.01.2023 KR 20230001332; 12.04.2023 KR 20230048285
(43) Date of publication of application: 24.07.2024
(73) Proprietor: SAMSUNG ELECTRONICS CO., LTD., Yeongtong-gu Suwon-si, 16677 (KR)
(72) Inventor: DO, Kyoungil, 16677 Suwon-si, Gyeonggi-do (KR); JUNG, Jinwoo, 16677 Suwon-si, Gyeonggi-do (KR); SONG, Jooyoung, 16677 Suwon-si, Gyeonggi-do (KR); JEON, Chanhee, 16677 Suwon-si, Gyeonggi-do (KR)
(74) Representative: Kuhnen & Wacker Patent- und Rechtsanwaltsbüro PartG mbB

(56) References cited:
- US-A1- 2002 050 615
- US-A1- 2008 088 993
- US-A1- 2013 009 204
- US-A1- 2015 214 210
- US-A1- 2016 056 146

## Description

### BACKGROUND

The present disclosure relates to a device for protecting circuits from electrostatic discharge, and more particularly, to a device for electrostatic discharge protection using a silicon controlled rectifier.

Electrostatic discharge (ESD) may cause malfunctions or even damage integrated circuits. Accordingly, an integrated circuit may include a component for ESD protection, and the component for ESD protection may protect an internal circuit from ESD generated from the outside of the integrated circuit. Due to the development of semiconductor processes, the size of elements included in integrated circuits may decrease, and the operating voltage of elements included in the integrated circuit may be reduced to reduce power consumption, and for higher performance, the frequency of signals input and output to the integrated circuit may be increased. Accordingly, components for ESD protection may be required to satisfy various requirements.

US 2015/214210 A1 discloses the following: An electronic device includes a first device terminal and a second device terminal. A first and a second thyristor are reverse-connected between the two device terminals. A first and a second MOS transistor are respectively coupled between the conduction electrodes (emitters and collectors) of the two NPN transistors of the two thyristors. A third MOS transistor is coupled between the emitters of the two NPN bipolar transistors of the two thyristors and a fourth MOS transistor is coupled between the bases of the two PNP bipolar transistors of the two thyristors. A gate region is common to all the MOS transistors and a semiconductor substrate region includes the substrates of all the MOS transistors.

US 2013/009204 A1 discloses the following: An ESD protection circuit includes a pad of an IC, circuitry coupled to the pad for buffering data, an RC power clamp on the IC, and first and second silicon controlled rectifier (SCR) circuits. The RC power clamp is coupled between a positive power supply terminal and a ground terminal. The first SCR circuit is coupled between the pad and the positive power supply terminal. The first SCR circuit has a first trigger input coupled to the RC power clamp circuit. The second SCR circuit is coupled between the pad and the ground terminal. The second SCR circuit has a second trigger input coupled to the RC power clamp circuit. At least one of the SCR circuits includes a gated diode configured to selectively provide a short or relatively conductive electrical path between the pad and one of the positive power supply terminal and the ground terminal.

US 2016/056146 A1 discloses the following: An ESD protection circuit may include an STI-bound SCR and a gated SCR that may be electrically in parallel with the STI-bound SCR. The gated SCR may be perpendicular to the STI-bound SCR in a plane of the semiconductor substrate. The gated SCR may trigger more quickly and turn on more quickly than the STI-bound SCR. The STI-bound SCR may form the main current path for an ESD event. A low capacitive load with rapid response to ESD events may thus be formed. In an embodiment, the anode of the two SCRs may be shared.

US 2002/050615 A1 discloses the following: A novel low-voltage-triggered semiconductor controlled rectified (LVTSCR) as an ESD protection device is provided in this document. The ESD protection device of the document has a lateral SCR (LSCR) structure with two electrodes and a MOS for triggering the LSCR. A dummy gate and a doped region are used to isolate the MOS from one of these two electrodes. The dummy gate is designed to block the formation of field-oxide layer formed in the device structure of the lateral SCR. Therefore, the proposed SCR device has a shorter current path in CMOS process, especially in the CMOS process with shallow trench isolation (STI) field-oxide layer. During an ESD, the current path in the ESD protection device is much shorter, and the turn-on speed and the ESD tolerance level are thereby enhanced.

US 2008/088993 A1 discloses the following: A protection circuit comprises a first PNP-type bipolar transistor and a second NPN-type bipolar transistor, wherein the base of the first transistor is connected to the collector of the second transistor and the collector of the first transistor is connected to the base of the second transistor, and wherein a MOS transistor is connected between the collector and the emitter of the second transistor.

### SUMMARY

Embodiments provide a device providing electrostatic discharge protection that meets various requirements using a silicon controlled rectifier.

The scope of the invention is defined by the appended claims.

According to an aspect of an example embodiment, a device includes: a first clamp circuit electrically connected between a first node and a second node; and a second clamp circuit electrically connected between the second node and a third node, wherein the first clamp circuit includes: a first silicon controlled rectifier (SCR) including a first region of a first conductivity type electrically connected to the first node, a second region of a second conductivity type, a third region of the first conductivity type, and a fourth region of the second conductivity type electrically connected to the second node; and a first gate electrode over a channel region, wherein the channel region includes a junction of the second region and the third region between the first region and the fourth region.

According to an aspect of an example embodiment, a device includes: a first clamp circuit electrically connected between a first node and a second node; and a second clamp circuit electrically connected between the second node and a third node, wherein the first clamp circuit includes: a first silicon controlled rectifier (SCR) including a first region of a first conductivity type electrically connected to the first node, a second region of a second conductivity type, a third region of the first conductivity type, and a fourth region of the second conductivity type electrically connected to the second node; and a first gate electrode configured to form a channel in one of the second region and the third region according to an applied voltage in a channel region between the second region and the third region.

### BRIEF DESCRIPTION OF THE DRAWINGS

The above and/or other aspects will be more clearly understood from the following detailed description taken in conjunction with the accompanying drawings in which:
FIG. 1 is a block diagram illustrating a device according to an embodiment;
FIG. 2 is a cross-sectional view showing a silicon controlled rectifier according to an example, not falling within the scope of the claimed invention;
FIG. 3 is a graph showing characteristics of a silicon controlled rectifier according to an embodiment;
FIG. 4 is a diagram illustrating a layout of a device according to an embodiment;
FIGS. 5A and 5B are circuit diagrams illustrating examples of devices according to embodiments;
FIGS. 6A and 6B are diagrams illustrating layouts of a device according to embodiments;
FIGS. 7A and 7B are circuit diagrams illustrating examples of devices according to embodiments;
FIGS. 8A and 8B are diagrams illustrating layouts of a device according to embodiments;
FIGS. 9A and 9B are circuit diagrams illustrating examples of devices according to embodiments;
FIGS. 10A and 10B are diagrams illustrating layouts of a device according to embodiments;
FIGS. 11A and 11B are circuit diagrams illustrating examples of devices according to embodiments;
FIGS. 12A and 12B are diagrams illustrating layouts of a device according to embodiments;
FIGS. 13A and 13B are circuit diagrams illustrating examples of devices according to embodiments;
FIGS. 14A and 14B are diagrams illustrating layouts of a device according to embodiments;
FIGS. 15A and 15B are circuit diagrams illustrating examples of devices according to embodiments;
FIGS. 16A and 16B are diagrams illustrating layouts of a device according to embodiments;
FIGS. 17A and 17B are circuit diagrams illustrating examples of devices according to embodiments;
FIGS. 18A and 18B are diagrams illustrating layouts of a device according to embodiments. ;
FIGS. 19A and 19B are circuit diagrams illustrating examples of devices according to embodiments;
FIGS. 20A and 20B are circuit diagrams illustrating examples of devices according to embodiments;
FIGS. 21A and 21B are circuit diagrams illustrating examples of devices according to embodiments;
FIGS. 22A and 22B are circuit diagrams illustrating examples of devices according to embodiments; and
FIG. 23 is a block diagram illustrating a device according to an embodiment.

### DETAILED DESCRIPTION

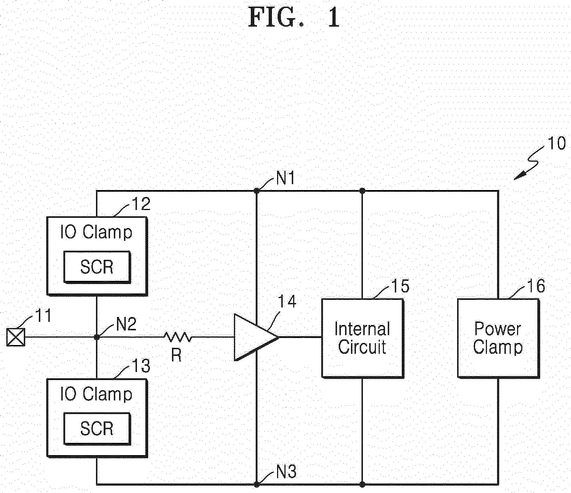

FIG. 1 is a block diagram illustrating a device 10 according to an embodiment. In some embodiments, the device 10 may include an integrated circuit manufactured by a semiconductor process. For example, the device 10 may be a chip or die, or may be a semiconductor package including at least one chip or die. As shown in FIG. 1, the device 10 may include an input/output (IO) pad 11, a first IO clamp 12, a second IO clamp 13, a resistor R, a buffer 14, an internal circuit 15, and a power clamp 16. Herein, a clamp may be referred to as a clamp circuit.

The IO pad 11 may be exposed to the outside of the device 10, and the signal received through the IO pad 11 may pass through the resistor R and the buffer 14 and be provided to the internal circuit 15. As shown in FIG. 1, the IO pad 11 may be connected to the first IO clamp 12 and the second IO clamp 13. Herein, when two or more components are electrically connected, the two or more components may be simply referred to as being connected. For example, when two components are connected through a resistor (e.g., parasitic resistor), the two components may be referred to as being electrically connected. Also, when two or more components are directly connected, the two or more components may be referred to as coupled. As shown in FIG. 1, the IO pad 11 may be connected to the second node N2.

The first IO clamp 12 may form a low-impedance discharge path between the IO pad 11 and the first node N1 when electrostatic discharge occurs in the IO pad 11. Similarly, the second IO clamp 13 may form a low impedance discharge path between the IO pad 11 and the third node N3 when electrostatic discharge occurs in the IO pad 11. Also, when electrostatic discharge occurs between the first node N1 and the second node N2, the power clamp 16 may form a low impedance discharge path between the first node N1 and the second node N2. Accordingly, the internal circuit 15 may be protected from electrostatic discharge by the first IO clamp 12, the second IO clamp 13, and the power clamp 16. Hereinafter, it is assumed that the positive supply voltage VDD is applied to the first node N1 and the negative supply voltage VSS is applied to the third node N3, but embodiments are not limited thereto. In some embodiments, a negative supply voltage VSS may be applied to the first node N1 and a positive supply voltage VDD may be applied to the second node N2.

Due to the development of semiconductor processes, the size of elements included in the internal circuit 15 may decrease and the junction depth and the thickness of a gate oxide may decrease. In addition, for low power consumption and high operating speed, the operating voltage of the internal circuit 15, that is, the voltage difference between the positive supply voltage VDD and the negative supply voltage VSS, may decrease and the frequency of the signal IO through the IO pad 11 may increase. Accordingly, the first IO clamp 12, the second IO clamp 13, and the power clamp 16 may be required to meet more stringent requirements, such as high current drive capability, low start-up voltage, low leakage current, low capacitance, and the like.

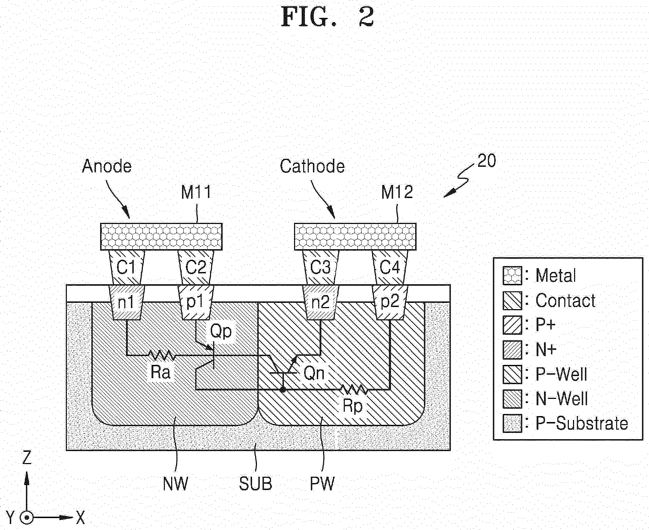

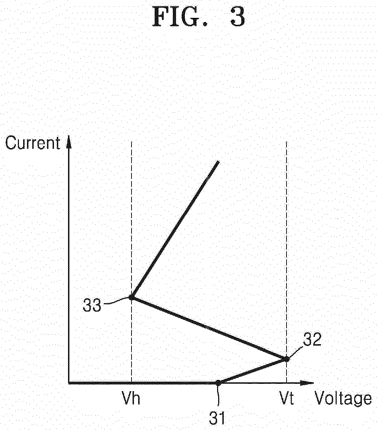

As shown in FIG. 1, each of the first IO clamp 12 and the second IO clamp 13 may include a silicon controlled rectifier (SCR). As described below with reference to FIG. 2, the SCR may have a high current density based on double injection, and may provide high electrostatic discharge performance per unit area, reduced area and capacitance. However, as described below with reference to FIG. 3, as a snapback element, the SCR may have a very high start-up voltage due to the high breakdown voltage between wells, and accordingly, the internal circuit 15 having a low operating voltage may be damaged by electrostatic discharge.

As described below with reference to the drawings, the first IO clamp 12 and/or the second IO clamp 13 may include a structure that generates a trigger current when electrostatic discharge occurs, and the trigger current may cause the SCR to form a low impedance path. Accordingly, elements of the internal circuit 15 having a low operating voltage may be safely protected from electrostatic discharge, and malfunction of the device 10 may be prevented. In addition, the additional area due to the structure generating the trigger current may be minimized, and thus, the efficiency of the device 10 may be increased.

FIG. 2 is a cross-sectional view showing a SCR 20 according to an example, not falling within the scope of the claimed invention, and FIG. 3 is a graph showing characteristics of the SCR 20. For example, the cross-sectional view of FIG. 2 shows a cross-section of the SCR 20 cut along a plane consisting of the X-axis and Z-axis and an equivalent circuit, and the graph of FIG. 3 shows the snapback curve of the SCR 20.

Herein, the X-axis direction and the Y-axis direction may be referred to as a first horizontal direction and a second horizontal direction, respectively, and the Z-axis direction may be referred to as a vertical direction. A plane consisting of the X and Y axes may be referred to as a horizontal plane, and a component disposed in the +Z direction relative to other components may be referred to as being above other components, and a component disposed in the -Z direction relative to other components may be referred to as being under the other component. In addition, the area of the component may refer to the size occupied by the component in a plane parallel to the horizontal plane, and the width of the component may refer to a length in a direction orthogonal to a direction in which the component extends. A surface exposed in the +Z direction may be referred to as a top surface, a surface exposed in the -Z direction may be referred to as a bottom surface, and a surface exposed in the ±X direction or ±Y direction may be referred to as a side surface. A pattern made of a conductive material may be referred to as a conductive pattern or simply as a pattern.

Referring to FIG. 2, the SCR 20 may include a PNP bipolar transistor Qp and an NPN bipolar transistor Qn, and bases and collectors of the PNP bipolar transistor Qp and NPN bipolar transistor Qn may be cross coupled to each other. The emitter of the PNP bipolar transistor Qp may be referred to as the anode of the SCR 20, the collector of the PNP bipolar transistor Qp and the base of the NPN bipolar transistor Qn, which are connected to each other, may be referred to as the gate of the SCR 20, and the emitter of the NPN bipolar transistor Qn may be referred to as the cathode of the SCR 20. The resistor Ra connected between the anode and the base of the PNP bipolar transistor Qp (or the collector of the NPN bipolar transistor Qn) may include an n-well NW resistor. In addition, the resistor Rp connected between the cathode and the base of the NPN bipolar transistor Qn (or the collector of the PNP bipolar transistor Qp) may include a p-well PW resistor.

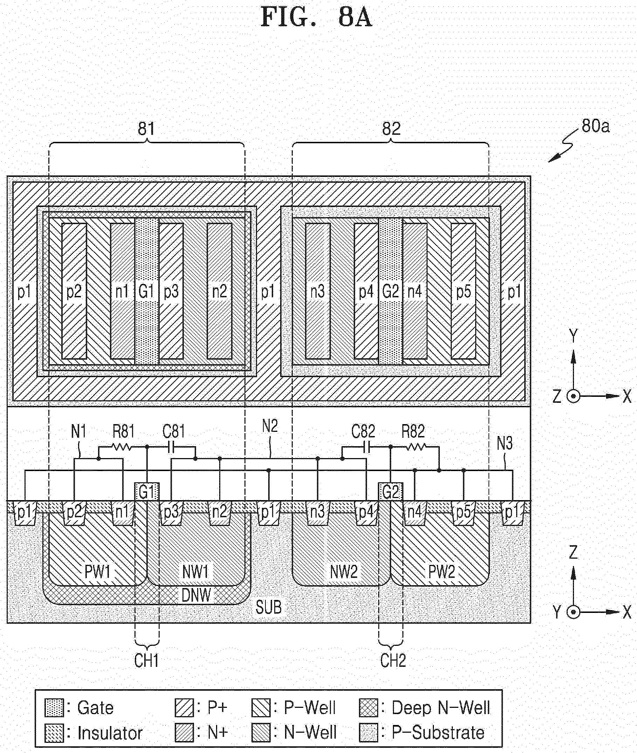

As shown in FIG. 2, the SCR 20 may be constituted by wells and doped regions disposed in the wells, each having its own conductivity type (e.g., p-type or n-type). For example, the n-well NW and the p-well PW may be disposed in the p-type substrate SUB. A first n+ region n1 and a first p+ region p1 may be disposed in the n-well NW, and a second n+ region n2 and a second p+ region p2 may be disposed in the p-well PW. Herein, the n+ region may have a concentration of n-type dopant higher than that of the n-well, and the p+ region may have a concentration of the p-type dopant higher than that of the p-well. In addition, as described below with reference to FIG. 8A and the like, n-wells and p-wells may be placed in deep n-wells, and the deep n-well may have a concentration of n-type dopant similar to or lower than that of the n-well and lower than that of the n+ region.

A first contact C1 and a second contact C2 may be disposed on the first n+ region n1 and the first p+ region p1, respectively, and the first contact C1 and the second contact C2 may be connected to each other by the first conductive pattern M11. A third contact C3 and a fourth contact C4 may be disposed on the second n+ region n2 and the second p+ region p2, respectively, and the third contact C3 and the fourth contact C4 may be connected to each other by the second conductive pattern M12. Accordingly, the PNP bipolar transistor Qp may be formed by the first p+ region p1 (i.e., emitter), n-well NW (i.e., base) and p-well PW (i.e., collector), and the NPN bipolar transistor Qn may be formed by a second n+ region n2 (i.e., emitter), a p-well PW (i.e., base) and an n-well NW (i.e., collector). In some embodiments, the first n+ region n1 and/or the second p+ region p2 may be omitted, and thus, the resistance Ra and/or the resistance Rp may be omitted. In some embodiments, a via may be placed between the contact and the conductive pattern.

Referring to FIG. 3, the SCR 20 may have characteristics corresponding to a snapback curve. For example, as the voltage between the anode and the cathode increases, breakdown between the n-well NW and the p-well PW may occur at the first point 31. At the second point 32, due to the voltage reaching the trigger voltage Vt, the PNP bipolar transistor Qp and the NPN bipolar transistor Qn may be turned on, respectively, and accordingly, the voltage may decrease and the current may increase. At a third point 33, the voltage may reach the bipolar hold voltage Vh, and an electrostatic discharge current may flow in the latch mode.

Due to the high breakdown voltage between the n-well NW and the p-well PW (i.e., the voltage at the first point 31), the trigger voltage Vt may reach, for example, about 18V to about 20V and may not be suitable for protecting elements of an internal circuit having a low operating voltage such as 3V or 1.5V. In addition, the bipolar hold voltage Vh may depend on the forward voltage drop, and if the bipolar hold voltage Vh is less than the sum of the operating voltage and margin of the internal circuit, after electrostatic discharge occurs, the PNP bipolar transistor Qp and the NPN bipolar transistor Qn may not turn off and signal distortion, device deterioration, and/or damage may occur. As described below with reference to the drawings, the trigger circuit may lower the trigger voltage Vt at the SCR 20 while increasing the bipolar hold voltage Vh.

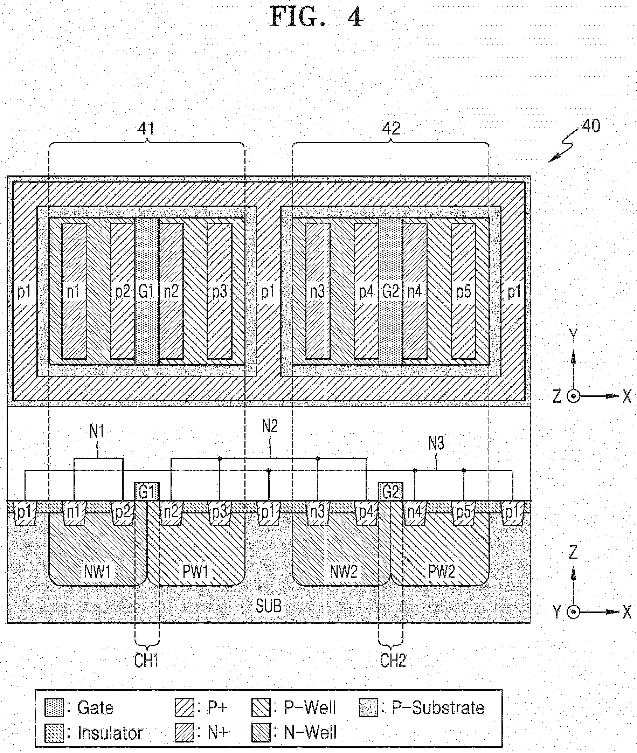

FIG. 4 is a diagram illustrating a layout of a device according to an embodiment. For example, FIG. 4 is a plan view and cross-sectional view of a layout 40 including a first SCR 41 and a second SCR 42 included in the first IO clamp 12 and the second IO clamp 13 of FIG. 1, respectively. For convenience of illustration, contacts and conductive patterns for interconnecting p+ regions, n+ regions, and gates are omitted.

Referring to FIG. 4, a first n-well NW1, a first p-well PW1, a second n-well NW2, and a second p-well PW2 may be disposed in the substrate SUB. The first p+ region p1 may surround the first SCR 41 and the second SCR 42 on the substrate SUB. The first p+ region p1 may be connected to the third node N3, that is, the cathode of the second SCR 42.

The first n+ region n1, the second p+ region p2, the second n+ region n2, and the third p+ region p3 may constitute the first SCR 41 together with the first n-well NW1 and the first p-well PW1. The first n+ region n1 and the second p+ region p2 may be connected to the first node N1, and the second n+ region n2 and the third p+ region p3 may be connected to the second node N2. The first gate electrode G1 may be disposed over the first channel region CH1 between the second p+ region p2 and the second n+ region n2, and the first gate electrode G1 may be disposed over a junction of the first n-well NW1 and the first p-well PW1. Accordingly, when a high voltage is applied to the first gate electrode G1, a channel may be formed in the first channel region CH1 of the first p-well PW1, and an n-type field effect transistor (NFET) in which the first n-well NW1 and the second n+ region n2 function as a source and a drain may be formed. On the other hand, when a low voltage is applied to the first gate electrode G1, a channel may be formed in the first channel region CH1 of the first n-well NW1, and a p-type field effect transistor (PFET) in which the second p+ region p2 and the second n+ region n2 function as a source and a drain may be formed. Accordingly, when a voltage due to electrostatic discharge is applied to the first gate electrode G1, a trigger current may be generated due to a channel formed in the first channel region CH1, and the first SCR 41 may be driven. In some embodiments, an insulating film (e.g., a dielectric film) may be disposed between the first gate electrode G1 and the first channel region CH1.

The third n+ region n3, the fourth p+ region p4, the fourth n+ region n4, and the fifth p+ region p5 may constitute the second SCR 42 together with the second n-well NW2 and the second p-well PW2. The third n+ region n3 and the fourth p+ region p4 may be connected to the second node N2, and the fourth n+ region n4 and the fifth p+ region p5 may be connected to the third node N3. The second gate electrode G2 may be disposed over the second channel region CH2 between the fourth p+ region p4 and the fourth n+ region n4, and the second gate electrode G2 may be disposed over the junction of the second n-well NW2 and the second p-well PW2. Accordingly, when a high voltage is applied to the second gate electrode G2, a channel may be formed in the second channel region CH2 of the second p-well PW2, and an NFET in which the second n-well NW2 and the fourth n+ region n4 function as a source and a drain may be formed. On the other hand, when a low voltage is applied to the second gate electrode G2, a channel may be formed in the second channel region CH2 of the second n-well NW2 and a PFET in which the fourth p+ region p4 and the fourth n+ region n4 function as a source and a drain may be formed. Accordingly, when a voltage due to electrostatic discharge is applied to the second gate electrode G2, due to a channel formed in the second channel region CH2, a trigger current may be generated and the second SCR 42 may be driven. In some embodiments, an insulating film (e.g., a dielectric film) may be disposed between the second gate electrode G2 and the second channel region CH2.

As shown in FIG. 4, the first gate electrode G1 may not increase the area of the first SCR 41, and the second gate electrode G2 may also not increase the area of the second SCR 42. Accordingly, the additional area due to the structure generating the trigger current may be minimized. Hereinafter, examples of a structure for generating voltages applied to gate electrodes are described with reference to drawings.

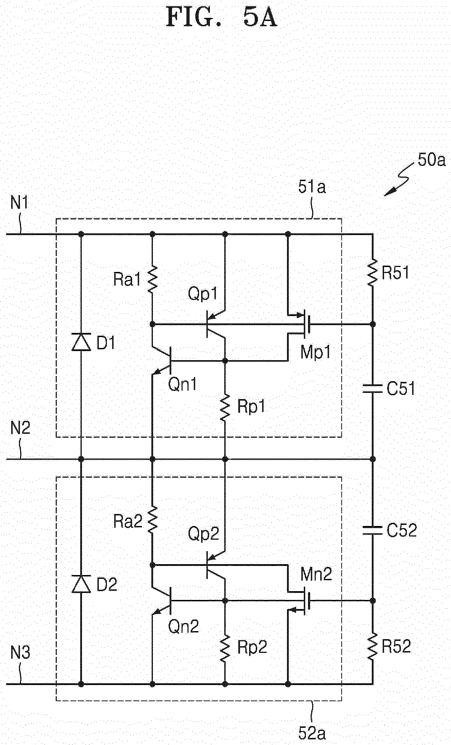

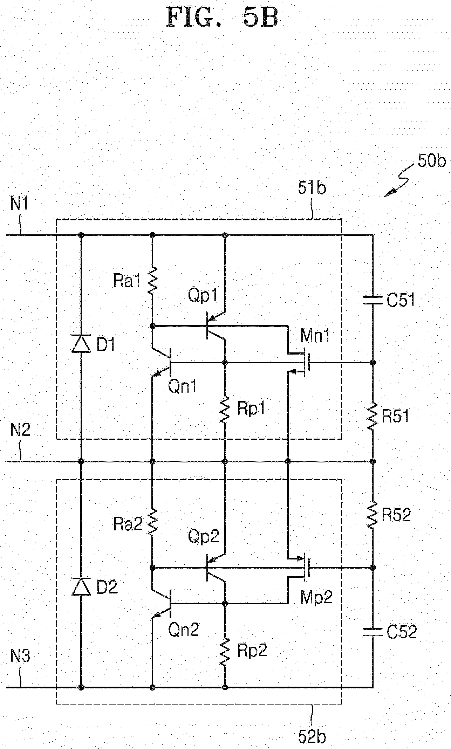

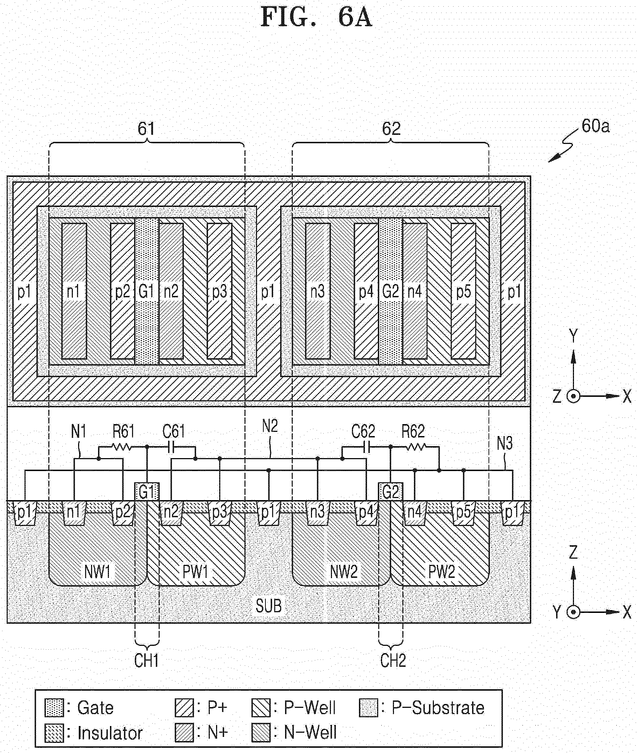

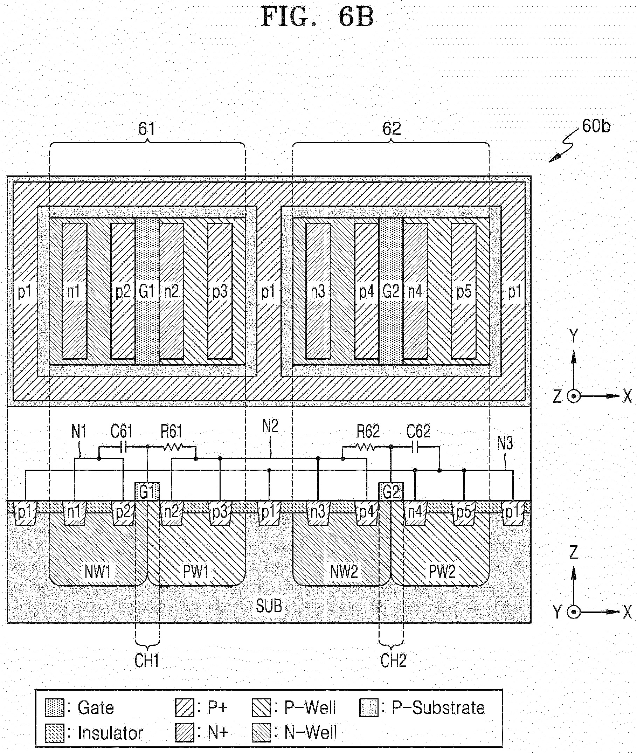

FIGS. 5A and 5B are circuit diagrams illustrating examples of devices according to embodiments. For example, the circuit diagram of FIG. 5A shows an equivalent circuit of a device 50a including a first IO clamp 51a and a second IO clamp 52a, and the circuit diagram of FIG. 5B shows an equivalent circuit of a device 50b including a first IO clamp 51b and a second IO clamp 52b. FIG. 6A provides exemplary semiconductor geometry corresponding to the equivalent circuit of FIG. 5A. FIG. 6B provides exemplary semiconductor geometry corresponding to the equivalent circuit of FIG. 5B.

Referring to FIG. 5A, the device 50a may include a first IO clamp 51a, a second IO clamp 52a, a first resistor R51, a second resistor R52, a first capacitor C51, and a second capacitor C52. The first IO clamp 51a may include a first PNP bipolar transistor Qp1, a first NPN bipolar transistor Qn1, and resistors Ra1 and Rp1 constituting a first SCR. Also, the first IO clamp 51a may include a first diode D1, and the first diode D1 may be formed by a junction of an n-well and a p-well. Similarly, the second IO clamp 52a may include a second PNP bipolar transistor Qp2, a second NPN bipolar transistor Qn2, and resistors Ra2 and Rp2 constituting the second SCR. In addition, the second IO clamp 52a may include a second diode D2, and the second diode D2 may be formed by a junction of an n-well and a p-well.

The first IO clamp 51a may include a first transistor Mp1, and as described above with reference to FIG. 4, the first transistor Mp1 may be formed by a gate electrode disposed over the channel region. As shown in FIG. 5A, a first resistor R51 may be connected between the first node N1 and the gate electrode of the first transistor Mp1, and a first capacitor C51 may be connected between the gate electrode of the first transistor Mp1 and the second node N2. When a positive electrostatic discharge voltage is generated between the first node N1 and the second node N2, the first capacitor C51 and the first resistor R51 may function as a high pass filter HPF, and accordingly, the first transistor Mp1 may operate like a turned-on PFET. For example, the source of the first transistor Mp1 may be pulled down by the first capacitor C51. Accordingly, a trigger current may flow from the first node N1 to the second node N2 by sequentially passing through the first transistor Mp1 and the first NPN bipolar transistor Qn1, and then, an electrostatic discharge current may flow through the first PNP bipolar transistor Qp1 and the first NPN bipolar transistor Qn1. When a negative electrostatic discharge voltage is generated between the first node N1 and the second node N2, an electrostatic discharge current may flow from the second node N2 to the first node N1 through the first diode D1.

The second IO clamp 52a may include a second transistor Mn2, and as described above with reference to FIG. 4, the second transistor Mn2 may be formed by a gate electrode disposed over the channel region. As shown in FIG. 5A, a second resistor R52 may be connected between the third node N3 and the gate electrode of the second transistor Mn2, and a second capacitor C52 may be connected between the gate electrode of the second transistor Mn2 and the second node N2. When a positive electrostatic discharge voltage is generated between the second node N2 and the third node N3, the second capacitor C52 and the second resistor R52 may function as a high pass filter HPF, and accordingly, the second transistor Mn2 may operate like a turned-on NFET. Accordingly, a trigger current may flow from the second node N2 to the third node N3 by sequentially passing through the second PNP bipolar transistor Qp2 and the second transistor Mn2, and then, an electrostatic discharge current may flow through the second PNP bipolar transistor Qp2 and the second NPN bipolar transistor Qn2. When a negative electrostatic discharge voltage is generated between the second node N2 and the third node N3, an electrostatic discharge current may flow from the third node N3 to the second node N2 through the second diode D2.

When an electrostatic discharge voltage is generated between the first node N1 and the third node N3, an electrostatic discharge current may flow by a combination of the SCR, the first diode D1 and the second diode D2 by the trigger current. For example, when a positive electrostatic discharge voltage is generated between the first node N1 and the third node N3, a trigger current may flow in the first IO clamp 51a and the second IO clamp 52a as described above. Also, when a negative electrostatic discharge voltage is generated between the first node N1 and the third node N3, the electrostatic discharge current may flow through the second diode D2 and the first diode D1.

Referring to FIG. 5B, the device 50b may include a first IO clamp 51b, a second IO clamp 52b, a first resistor R51, a second resistor R52, a first capacitor C51, and a second capacitor C52. The first IO clamp 51b may include a first PNP bipolar transistor Qp1, a first NPN bipolar transistor Qn1, and resistors Ra1 and Rp1 constituting a first SCR. Also, the first IO clamp 51b may include a first diode D1, and the first diode D1 may be formed by a junction of an n-well and a p-well. Similarly, the second IO clamp 52b may include a second PNP bipolar transistor Qp2, a second NPN bipolar transistor Qn2, and resistors Ra2 and Rp2 constituting the second SCR. In addition, the second IO clamp 52b may include a second diode D2, and the second diode D2 may be formed by a junction of an n-well and a p-well.

The first IO clamp 51b may include a first transistor Mn1, and as described above with reference to FIG. 4, the first transistor Mn1 may be formed by a gate electrode disposed over the channel region. As shown in FIG. 5B, a first capacitor C51 may be connected between the first node N1 and the gate electrode of the first transistor Mn1, and a first resistor R51 may be connected between the gate electrode of the first transistor Mn1 and the second node N2. When a positive electrostatic discharge voltage is generated between the first node N1 and the second node N2, the first capacitor C51 and the first resistor R51 may function as a high pass filter HPF, and accordingly, the first transistor Mn1 may operate like a turned-on NFET. Accordingly, a trigger current may flow from the first node N1 to the second node N2 by sequentially passing through the first PNP bipolar transistor Qp1 and the first transistor Mn1, and then, an electrostatic discharge current may flow through the first PNP bipolar transistor Qp1 and the first NPN bipolar transistor Qn1. When a negative electrostatic discharge voltage is generated between the first node N1 and the second node N2, an electrostatic discharge current may flow from the second node N2 to the first node N1 through the first diode D1.

The second IO clamp 52b may include a second transistor Mp2, and as described above with reference to FIG. 4, the second transistor Mp2 may be formed by a gate electrode disposed over the channel region. As shown in FIG. 5B, a second capacitor C52 may be connected between the third node N3 and the gate electrode of the second transistor Mp2, and a second resistor R52 may be connected between the gate electrode of the second transistor Mp2 and the second node N2. When a positive electrostatic discharge voltage is generated between the second node N2 and the third node N3, the second capacitor C52 and the second resistor R52 may function as a high pass filter HPF, and accordingly, the second transistor Mp2 may operate like a turned-on PFET. Accordingly, a trigger current may flow from the second node N2 to the third node N3 by sequentially passing through the second transistor Mp2 and the second NPN bipolar transistor Qn2, and then, an electrostatic discharge current may flow through the second PNP bipolar transistor Qp2 and the second NPN bipolar transistor Qn2. When a negative electrostatic discharge voltage is generated between the second node N2 and the third node N3, an electrostatic discharge current may flow from the third node N3 to the second node N2 through the second diode D2.

When an electrostatic discharge voltage is generated between the first node N1 and the third node N3, an electrostatic discharge current may flow by a combination of the SCR, the first diode D1 and the second diode D2 by the trigger current. For example, when a positive electrostatic discharge voltage is generated between the first node N1 and the third node N3, a trigger current may flow in the first IO clamp 51b and the second IO clamp 52b as described above. Also, when a negative electrostatic discharge voltage is generated between the first node N1 and the third node N3, the electrostatic discharge current may flow through the second diode D2 and the first diode D1.

FIGS. 6A and 6B are diagrams illustrating layouts of a device according to embodiments. For example, FIG. 6A shows top and cross-sectional views of a layout 60a of the device 50a of FIG. 5A, and FIG. 6B shows top and cross-sectional views of a layout 60b of the device 50b of FIG. 5B. For convenience of illustration, resistors and capacitors are each shown as symbols. In the following descriptions of FIGS. 6A and 6B, descriptions as with those of FIG. 4 will be omitted.

Referring to FIG. 6A, a first n-well NW1, a first p-well PW1, a second n-well NW2, and a second p-well PW2 may be disposed in a substrate SUB. The first p+ region p1 may surround the first SCR 61 and the second SCR 62 on the substrate SUB. The first p+ region p1 may be connected to the third node N3, that is, the cathode of the second SCR 62. The first gate electrode G1 may correspond to the gate electrode of the first transistor Mp1 of FIG. 5A, and the second gate electrode G2 may correspond to the gate electrode of the second transistor Mn2 of FIG. 5A. In an embodiment, the first n-well NW1 may be a first well in the substrate SUB, the first p-well PW1 may be a second well in the substrate SUB, the second p+ region p2 may be a first diffused region at a first surface of the first well, and the second n+ region n2 may be a second diffused region at a second surface of the second well.

A first resistor R61 may be connected between the first node N1 to which the first n+ region n1 and the second p+ region p2 are connected and the first gate electrode G1. In addition, a first capacitor C61 may be connected between the second node N2 to which the second n+ region n2, the third p+ region p3, the third n+ region n3, and the fourth p+ region p4 are connected and the first gate electrode G1. A second resistor R62 may be connected between a third node N3 to which the first p+ region p1, the fourth n+ region n4, and the fifth p+ region p5 are connected and the second gate electrode G2. Also, a second capacitor C62 may be connected between the second node N2 and the second gate electrode G2.

Referring to FIG. 6B, a first n-well NW1, a first p-well PW1, a second n-well NW2, and a second p-well PW2 may be disposed in a substrate SUB. The first p+ region p1 may surround the first SCR 61 and the second SCR 62 on the substrate SUB. The first p+ region p1 may be connected to the third node N3, that is, the cathode of the second SCR 62. The first gate electrode G1 may correspond to the gate electrode of the first transistor Mn1 of FIG. 5B, and the second gate electrode G2 may correspond to the gate electrode of the second transistor Mp2 of FIG. 5B.

The first capacitor C61 may be connected between the first node N1 to which the first n+ region n1 and the second p+ region p2 are connected and the first gate electrode G1. In addition, the first resistor R61 may be connected between the second node N2 to which the second n+ region n2, the third p+ region p3, the third n+ region n3, and the fourth p+ region p4 are connected and the first gate electrodes G1. The second capacitor C62 may be connected between the third node N3 to which the first p+ region p1, the fourth n+ region n4, and the fifth p+ region p5 are connected and the second gate electrode G2. Also, the second resistor R62 may be connected between the second node N2 and the second gate electrode G2.

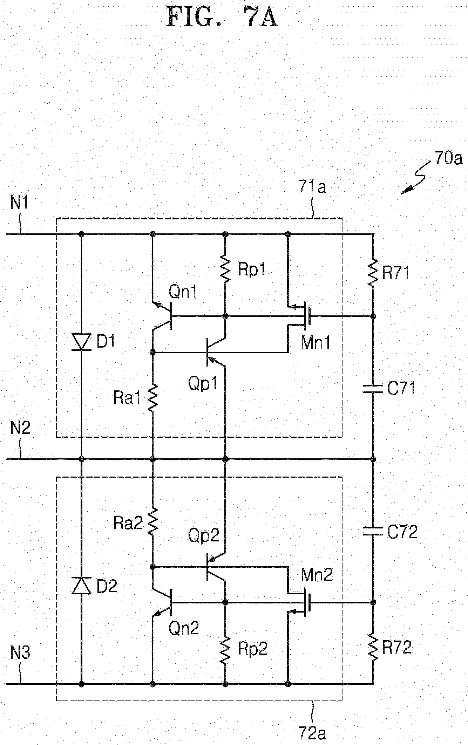

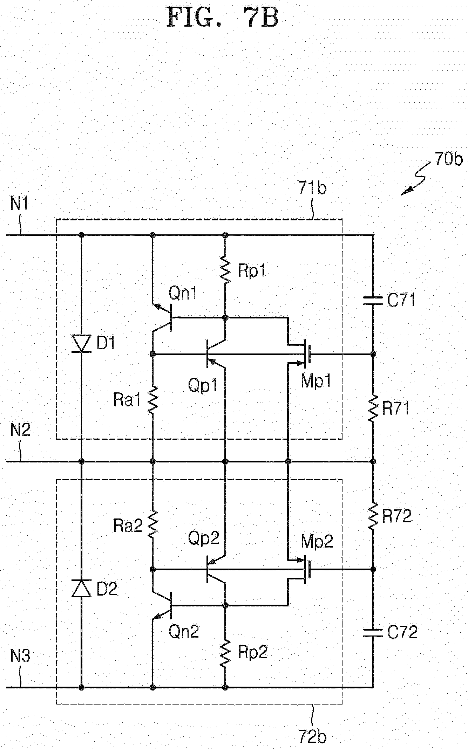

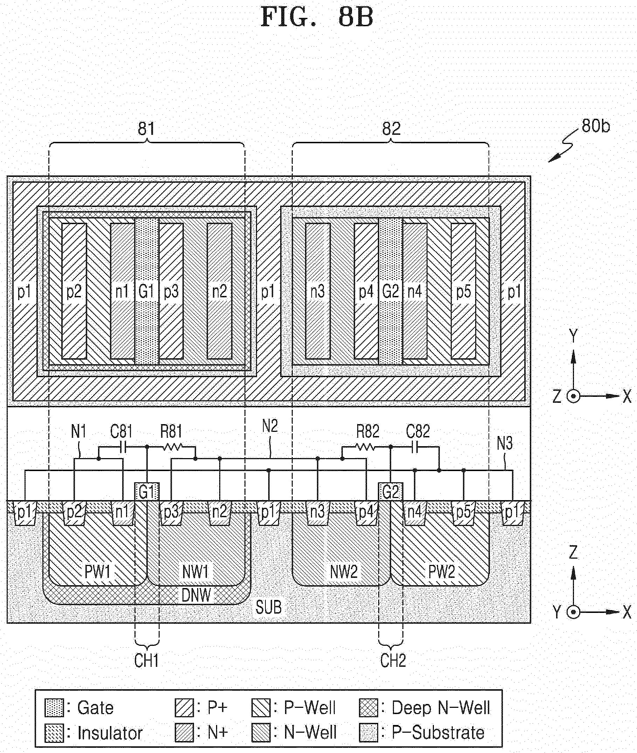

FIGS. 7A and 7B are circuit diagrams illustrating examples of devices according to embodiments. For example, the circuit diagram of FIG. 7A shows an equivalent circuit of a device 70a including a first IO clamp 71a and a second IO clamp 72a, and the circuit diagram of FIG. 7B shows an equivalent circuit of a device 70b including a first IO clamp 71b and a second IO clamp 72b. In the following, descriptions of FIGS. 7A and 7B with reference to the drawings, which are the same as those given above are omitted. FIG. 8A provides exemplary semiconductor geometry corresponding to the equivalent circuit of FIG. 7A. FIG. 8B provides exemplary semiconductor geometry corresponding to the equivalent circuit of FIG. 7B.

Referring to FIG. 7A, the first IO clamp 71a may include a first transistor Mn1, and as described above with reference to FIG. 4, the first transistor Mn1 may be formed by a gate electrode disposed over the channel region. As shown in FIG. 7A, a first resistor R71 may be connected between the first node N1 and the gate electrode of the first transistor Mn1, and a first capacitor C71 may be connected between the gate electrode of the first transistor Mn1 and the second node N2. When a negative electrostatic discharge voltage is generated between the first node N1 and the second node N2, the first capacitor C71 and the first resistor R71 may function as a high pass filter HPF, and accordingly, the first transistor Mn1 may operate like a turned-on NFET. Accordingly, a trigger current may flow from the second node N2 to the first node N1 by sequentially passing through the first PNP bipolar transistor Qp1 and the first transistor Mn1, and then, an electrostatic discharge current may flow through the first NPN bipolar transistor Qn1 and the first PNP bipolar transistor Qp1. When a positive electrostatic discharge voltage is generated between the first node N1 and the second node N2, an electrostatic discharge current may flow from the first node N1 to the second node N2 through the first diode D1.

The second IO clamp 72a may include a second transistor Mn2, and as described above with reference to FIG. 4, the second transistor Mn2 may be formed by a gate electrode disposed over the channel region. As shown in FIG. 7A, a second resistor R72 may be connected between the third node N3 and the gate electrode of the second transistor Mn2, and a second capacitor C72 may be connected between the gate electrode of the second transistor Mn2 and the second node N2. When a positive electrostatic discharge voltage is generated between the second node N2 and the third node N3, the second capacitor C72 and the second resistor R72 may function as a high pass filter HPF, and accordingly, the second transistor Mn2 may operate like a turned-on NFET. Accordingly, a trigger current may flow from the second node N2 to the third node N3 by sequentially passing through the second PNP bipolar transistor Qp2 and the second transistor Mn2, and then, an electrostatic discharge current may flow through the second PNP bipolar transistor Qp2 and the second NPN bipolar transistor Qn2. When a negative electrostatic discharge voltage is generated between the second node N2 and the third node N3, an electrostatic discharge current may flow from the third node N3 to the second node N2 through the second diode D2.

Referring to FIG. 7B, the first IO clamp 71b may include a first transistor Mp1, and as described above with reference to FIG. 4, the first transistor Mp1 may be formed by a gate electrode disposed over the channel region. As shown in FIG. 7B, a first capacitor C71 may be connected between the first node N1 and the gate electrode of the first transistor Mp1, and a first resistor R71 may be connected between the gate electrode of the first transistor Mp1 and the second node N2. When a negative electrostatic discharge voltage is generated between the first node N1 and the second node N2, the first capacitor C71 and the first resistor R71 may function as a high pass filter HPF, and accordingly, the first transistor Mp1 may operate like a turned-on PFET. Accordingly, a trigger current may flow from the second node N2 to the first node N1 by sequentially passing through the first transistor Mp1 and the first NPN bipolar transistor Qn1, and then, an electrostatic discharge current may flow through the first PNP bipolar transistor Qp1 and the first NPN bipolar transistor Qn1. When a positive electrostatic discharge voltage is generated between the first node N1 and the second node N2, an electrostatic discharge current may flow from the first node N1 to the second node N2 through the first diode D1.

The second IO clamp 72b may include a second transistor Mp2, and as described above with reference to FIG. 4, the second transistor Mp2 may be formed by a gate electrode disposed over the channel region. As shown in FIG. 7B, a second capacitor C72 may be connected between the third node N3 and the gate electrode of the second transistor Mp2, and a second resistor R72 may be connected between the gate electrode of the second transistor Mp2 and the second node N2. When a positive electrostatic discharge voltage is generated between the second node N2 and the third node N3, the second capacitor C72 and the second resistor R72 may function as a high pass filter HPF, and accordingly, the second transistor Mp2 may operate like a turned-on PFET. Accordingly, a trigger current may flow from the second node N2 to the third node N3 by sequentially passing through the second transistor Mp2 and the second NPN bipolar transistor Qn2, and then, an electrostatic discharge current may flow through the second PNP bipolar transistor Qp2 and the second NPN bipolar transistor Qn2. When a negative electrostatic discharge voltage is generated between the second node N2 and the third node N3, an electrostatic discharge current may flow from the third node N3 to the second node N2 through the second diode D2.

FIGS. 8A and 8B are diagrams illustrating layouts of a device according to embodiments. For example, FIG. 8A shows top and cross-sectional views of a layout 80a of the device 70a in FIG. 7A, and FIG. 8B shows top and cross-sectional views of a layout 80b of the device 70b in FIG. 7B. For convenience of illustration, resistors and capacitors are each shown as symbols. In the following descriptions of FIGS. 8A and 8B, descriptions that are the same as those of FIG. 4 will be omitted.

Referring to FIG. 8A, a deep n-well DNW, a second n-well NW2 and a second p-well PW2 may be disposed in the substrate SUB, and a first p-well PW1 and a first n-well NW1 may be disposed in the deep n-well DNW. The first p+ region p1 may surround the first SCR 81 (or deep n-well DNW) and the second SCR 82 on the substrate SUB. The first p+ region p1 may be connected to the third node N3, that is, the cathode of the second SCR 82. The first gate electrode G1 may correspond to the gate electrode of the first transistor Mn1 of FIG. 7A, and the second gate electrode G2 may correspond to the gate electrode of the second transistor Mn2 of FIG. 7A. In an embodiment, the first p-well PW1 may be a first well in the deep n-well DNW in the substrate SUB, the first n-well NW1 may be a second well in the deep n-well DNW, the first n+ region n1 may be a first diffused region at a first surface of the first well, and the third p+ region p3 may be a second diffused region at a second surface of the second well.

The first resistor R81 may be connected between the first node N1 to which the second p+ region p2 and the first n+ region n1 are connected and the first gate electrode G1. In addition, the first capacitor C81 is connected between the second node N2 to which the third p+ region p3, the second n+ region n2, the third n+ region n3, and the fourth p+ region p4 are connected and the first gate electrode G1. The second resistor R82 is connected between the third node N3 to which the first p+ region p1, the fourth n+ region n4, and the fifth p+ region p5 are connected and the second gate electrode G2. Also, the second capacitor C82 may be connected between the second node N2 and the second gate electrode G2.

Referring to FIG. 8B, a deep n-well DNW, a second n-well NW2 and a second p-well PW2 may be disposed in a substrate SUB, and a first n-well NW1 and a first p-well PW1 may be disposed in the deep n-well DNW. The first p+ region p1 may surround the first SCR 81 (or deep n-well DNW) and the second SCR 82 on the substrate SUB. The first p+ region p1 may be connected to the third node N3, that is, the cathode of the second SCR 82. The first gate electrode G1 may correspond to the gate electrode of the first transistor Mp1 of FIG. 7B, and the second gate electrode G2 may correspond to the gate electrode of the second transistor Mp2 of FIG. 7B.

The first capacitor C81 may be connected between the first node N1 to which the second p+ region p2 and the first n+ region n1 are connected and the first gate electrode G1. In addition, the first resistor R81 may be connected between the second node N2 to which the second n+ region n2, the third p+ region p3, the third n+ region n3, and the fourth p+ region p4 are connected and the first gate electrode G1. The second capacitor C82 may be connected between the third node N3 to which the first p+ region p1, the fourth n+ region n4, and the fifth p+ region p5 are connected and the second gate electrode G2. Also, the second resistor R82 may be connected between the second node N2 and the second gate electrode G2.

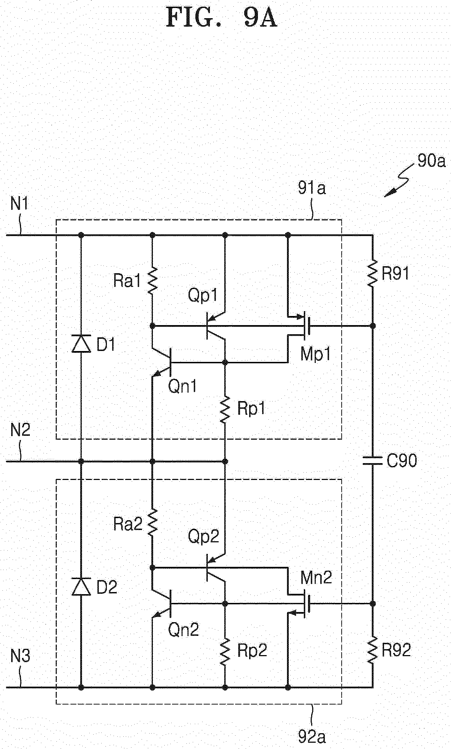

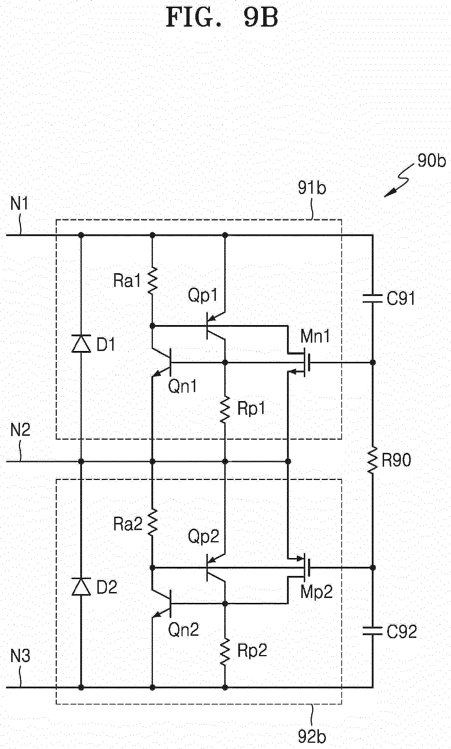

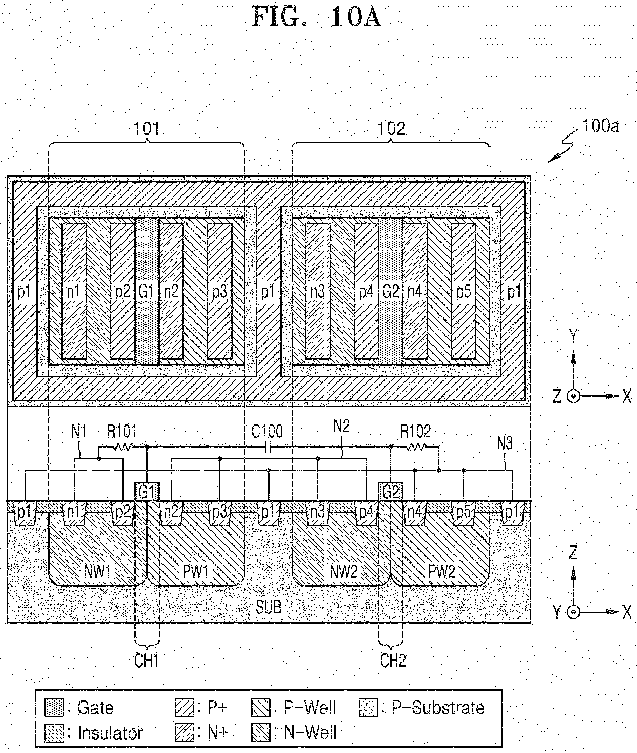

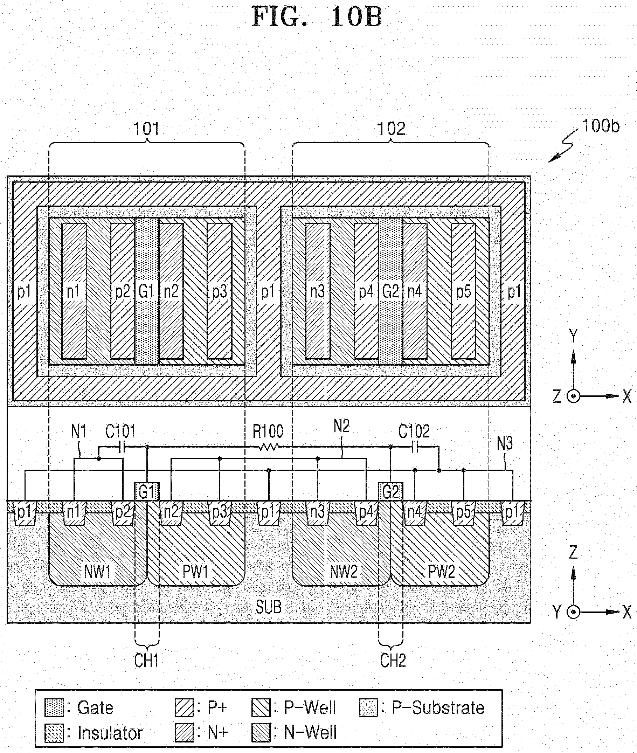

FIGS. 9A and 9B are circuit diagrams illustrating examples of devices according to embodiments. For example, the circuit diagram of FIG. 9A shows an equivalent circuit of a device 90a including a first IO clamp 91a and a second IO clamp 92a, and the circuit diagram of FIG. 9B shows an equivalent circuit of a device 90b including a first IO clamp 91b and a second IO clamp 92b. In the following, descriptions of FIGS. 9A and 9B with reference to the drawings, which are the same as those given above are omitted. FIG. 10A provides example semiconductor geometry corresponding to the equivalent circuit of FIG. 9A. FIG. 10B provides example semiconductor geometry corresponding to the equivalent circuit of FIG. 9B.

Referring to FIG. 9A, the first IO clamp 91a may include a first transistor Mp1, and as described above with reference to FIG. 4, the first transistor Mp1 may be formed by a gate electrode disposed over the channel region. As shown in FIG. 9A, a first resistor R91 may be connected between the first node N1 and the gate electrode of the first transistor Mp1, and a capacitor C90 may be connected between the gate electrode of the first transistor Mp1 and the gate electrode of the second transistor Mp2 described below. When a positive electrostatic discharge voltage is generated between the first node N1 and the second node N2, the first transistor Mp1 may operate like a turned-on PFET. Accordingly, a trigger current may flow from the first node N1 to the second node N2 by sequentially passing through the first transistor Mp1 and the first NPN bipolar transistor Qn1, and then, an electrostatic discharge current may flow through the first PNP bipolar transistor Qp1 and the first NPN bipolar transistor Qn1. When a negative electrostatic discharge voltage is generated between the first node N1 and the second node N2, an electrostatic discharge current may flow from the second node N2 to the first node N1 through the first diode D1.

The second IO clamp 92a may include a second transistor Mn2, and as described above with reference to FIG. 4, the second transistor Mn2 may be formed by a gate electrode disposed over the channel region. As shown in FIG. 9A, a second resistor R92 may be connected between the third node N3 and the gate electrode of the second transistor Mn2, and a capacitor C90 may be connected between the gate electrode of the second transistor Mn2 and the gate electrode of the first transistor Mn1. When a positive electrostatic discharge voltage is generated between the second node N2 and the third node N3, the second transistor Mn2 may operate like a turned-on NFET. Accordingly, a trigger current may flow from the second node N2 to the third node N3 by sequentially passing through the second PNP bipolar transistor Qp2 and the second transistor Mn2, and then, an electrostatic discharge current may flow through the second PNP bipolar transistor Qp2 and the second NPN bipolar transistor Qn2. When a negative electrostatic discharge voltage is generated between the second node N2 and the third node N3, an electrostatic discharge current may flow from the third node N3 to the second node N2 through the second diode D2.

Referring to FIG. 9B, the first IO clamp 91b may include a first transistor Mn1, and as described above with reference to FIG. 4, the first transistor Mn1 may be formed by a gate electrode disposed over the channel region. As shown in FIG. 9B, a first capacitor C91 may be connected between the first node N1 and the gate electrode of the first transistor Mn1, and a resistor R90 may be connected between the gate electrode of the first transistor Mn1 and the gate electrode of the second transistor Mp2 described below. When a positive electrostatic discharge voltage is generated between the first node N1 and the second node N2, the first capacitor C91 and the resistor R90 may function as a high pass filter HPF, and accordingly, the first transistor Mn1 may operate like a turned-on NFET. Accordingly, a trigger current may flow from the first node N1 to the second node N2 by sequentially passing through the first PNP bipolar transistor Qp1 and the first transistor Mn1, and then, an electrostatic discharge current may flow through the first PNP bipolar transistor Qp1 and the first NPN bipolar transistor Qn1. When a negative electrostatic discharge voltage is generated between the first node N1 and the second node N2, an electrostatic discharge current may flow from the second node N2 to the first node N1 through the first diode D1.

The second IO clamp 92b may include a second transistor Mp2, and as described above with reference to FIG. 4, the second transistor Mp2 may be formed by a gate electrode disposed over the channel region. As shown in FIG. 9B, a second capacitor C92 may be connected between the third node N3 and the gate electrode of the second transistor Mp2, and a resistor R90 may be connected between the gate electrode of the second transistor Mp2 and the gate electrode of the first transistor Mn1. When a positive electrostatic discharge voltage is generated between the second node N2 and the third node N3, the second capacitor C92 and the resistor R90 may function as a high pass filter HPF, and accordingly, the second transistor Mp2 may operate like a turned-on PFET. Accordingly, a trigger current may flow from the second node N2 to the third node N3 by sequentially passing through the second transistor Mp2 and the second NPN bipolar transistor Qn2, and then, an electrostatic discharge current may flow through the second PNP bipolar transistor Qp2 and the second NPN bipolar transistor Qn2. When a negative electrostatic discharge voltage is generated between the second node N2 and the third node N3, an electrostatic discharge current may flow from the third node N3 to the second node N2 through the second diode D2.

FIGS. 10A and 10B are diagrams illustrating layouts of a device according to embodiments. For example, FIG. 10A shows top and cross-sectional views of a layout 100a of the device 90a of FIG. 9A, and FIG. 10B shows top and cross-sectional views of a layout 100b of the device 90b of FIG. 9B. For convenience of illustration, resistors and capacitors are each shown as symbols. In the following descriptions of FIGS. 10A and 10B, descriptions that are the same as those of FIG. 4 will be omitted.

Referring to FIG. 10A, a first n-well NW1, a first p-well PW1, a second n-well NW2, and a second p-well PW2 may be disposed in a substrate SUB. The first p+ region p1 may surround the first SCR 101 and the second SCR 102 on the substrate SUB. The first p+ region p1 may be connected to the third node N3, that is, the cathode of the second SCR 102. The first gate electrode G1 may correspond to the gate electrode of the first transistor Mp1 of FIG. 9A, and the second gate electrode G2 may correspond to the gate electrode of the second transistor Mn2 of FIG. 9A.

The first resistor R101 may be connected between the first node N1 to which the first n+ region n1 and the second p+ region p2 are connected and the first gate electrode G1. The second resistor R102 is connected between the third node N3 to which the first p+ region p1, the fourth n+ region n4, and the fifth p+ region p5 are connected and the second gate electrode G2. Also, the capacitor C100 may be connected between the first gate electrode G1 and the second gate electrode G2. The second n+ region n2, the third p+ region p3, the third n+ region n3, and the fourth p+ region p4 may be connected to the second node N2.

Referring to FIG. 10B, a first n-well NW1, a first p-well PW1, a second n-well NW2, and a second p-well PW2 may be disposed in the substrate SUB. The first p+ region p1 may surround the first SCR 101 and the second SCR 102 on the substrate SUB. The first p+ region p1 may be connected to the third node N3, that is, the cathode of the second SCR 102. The first gate electrode G1 may correspond to the gate electrode of the first transistor Mn1 of FIG. 9B, and the second gate electrode G2 may correspond to the gate electrode of the second transistor Mp2 of FIG. 9B.

The first capacitor C101 may be connected between the first node N1 to which the first n+ region n1 and the second p+ region p2 are connected and the first gate electrode G1. The second capacitor C102 may be connected between the third node N3 to which the first p+ region p1, the fourth n+ region n4, and the fifth p+ region p5 are connected and the second gate electrode G2. Also, the resistor R100 may be connected between the first gate electrode G1 and the second gate electrode G2. The second n+ region n2, the third p+ region p3, the third n+ region n3, and the fourth p+ region p4 may be connected to the second node N2.

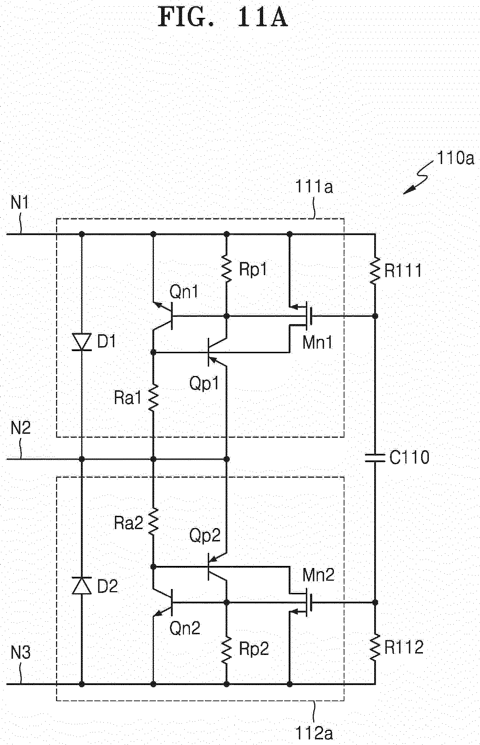

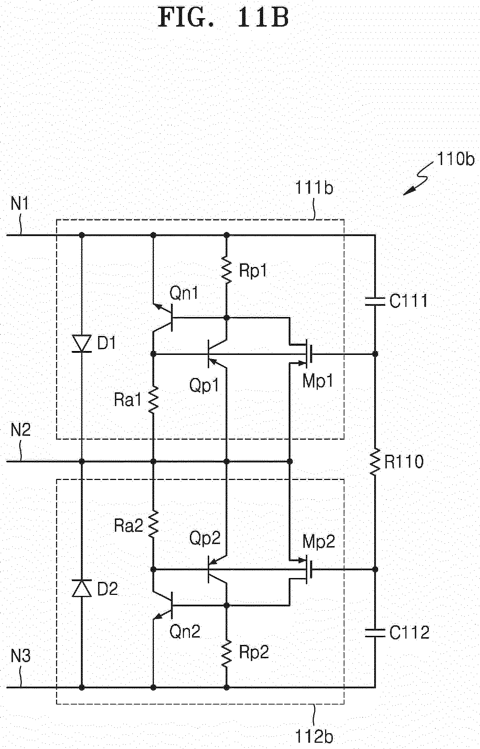

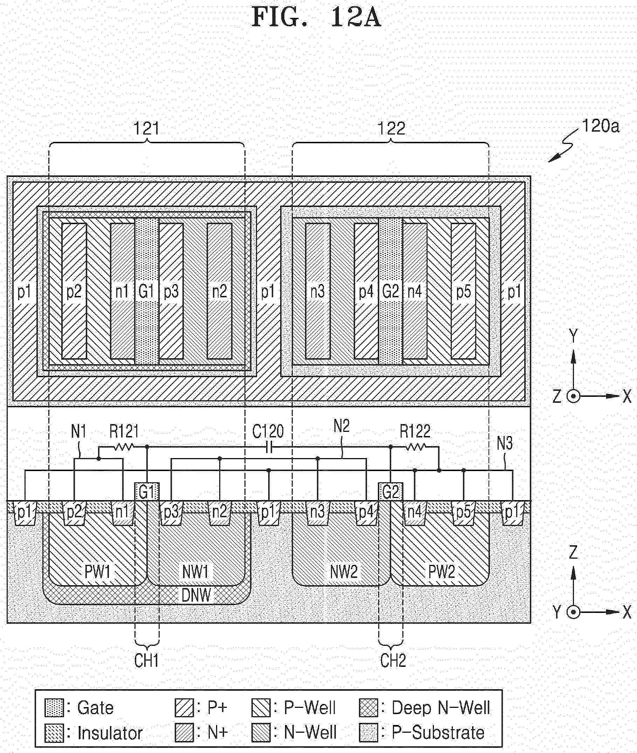

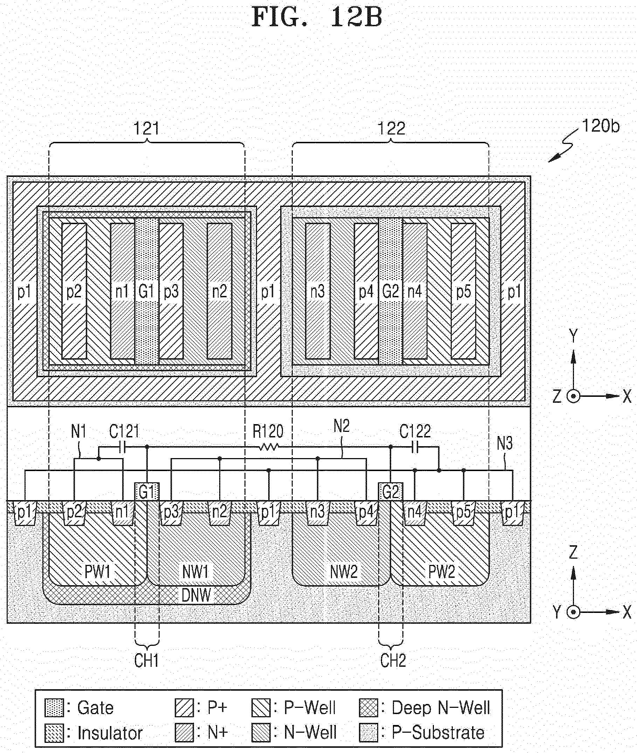

FIGS. 11A and 11B are circuit diagrams illustrating examples of devices according to embodiments. For example, the circuit diagram of FIG. 11A shows an equivalent circuit of a device 110a including a first IO clamp 111a and a second IO clamp 112a, and the circuit diagram of FIG. 11B shows an equivalent circuit of a device 110b including a first IO clamp 111b and a second IO clamp 112b. In the following, descriptions of FIGS. 11A and 11B with reference to the drawings, which are the same as those given above are omitted. FIG. 12A provides an example semiconductor geometry corresponding to the equivalent circuit of FIG. 11A. FIG. 12B provides an example semiconductor geometry corresponding to the equivalent circuit of FIG. 11B. The orientation of the first diode D1 from anode at N1 to cathode at N2 is provided by the deep n-well DNW.

Referring to FIG. 11A, the first IO clamp 111a may include a first transistor Mn1, and as described above with reference to FIG. 4, the first transistor Mn1 may be formed by a gate electrode disposed over the channel region. As shown in FIG. 11A, a first resistor R111 may be connected between the first node N1 and the gate electrode of the first transistor Mn1, and a capacitor C110 may be connected between the gate electrode of the first transistor Mn1 and the gate electrode of the second transistor Mn2 described below. When a negative electrostatic discharge voltage is generated between the first node N1 and the second node N2, the first transistor Mn1 may operate like a turned-on NFET. Accordingly, a trigger current may flow from the second node N2 to the first node N1 by sequentially passing through the first NPN bipolar transistor Qn1 and the first transistor Mn1, and then, an electrostatic discharge current may flow through the first PNP bipolar transistor Qp1 and the first NPN bipolar transistor Qn1. When a positive electrostatic discharge voltage is generated between the first node N1 and the second node N2, an electrostatic discharge current may flow from the first node N1 to the second node N2 through the first diode D1.

The second IO clamp 112a may include a second transistor Mn2, and as described above with reference to FIG. 4, the second transistor Mn2 may be formed by a gate electrode disposed over the channel region. As shown in FIG. 11A, a second resistor R112 may be connected between the third node N3 and the gate electrode of the second transistor Mn2, and a capacitor C110 may be connected between the gate electrode of the second transistor Mn2 and the gate electrode of the first transistor Mn1. When a positive electrostatic discharge voltage is generated between the second node N2 and the third node N3, the second transistor Mn2 may operate like a turned-on NFET. Accordingly, a trigger current may flow from the second node N2 to the third node N3 by sequentially passing through the second PNP bipolar transistor Qp2 and the second transistor Mn2, and then, an electrostatic discharge current may flow through the second PNP bipolar transistor Qp2 and the second NPN bipolar transistor Qn2. When a negative electrostatic discharge voltage is generated between the second node N2 and the third node N3, an electrostatic discharge current may flow from the third node N3 to the second node N2 through the second diode D2.

Referring to FIG. 11B, the first IO clamp 111b may include a first transistor Mp1, and as described above with reference to FIG. 4, the first transistor Mp1 may be formed by a gate electrode disposed over the channel region. As shown in FIG. 11B, a first capacitor C111 may be connected between the first node N1 and the gate electrode of the first transistor Mp1, and a resistor R110 may be connected between the gate electrode of the first transistor Mp1 and the gate electrode of the second transistor Mp2 described below. When a negative electrostatic discharge voltage is generated between the first node N1 and the second node N2, the first capacitor C111 and the resistor R110 may function as a high pass filter HPF, and accordingly, the first transistor Mp1 may operate like a turned-on PFET. Accordingly, a trigger current may flow from the second node N2 to the first node N1 by sequentially passing through the first transistor Mp1 and the first NPN bipolar transistor Qn1, and then, an electrostatic discharge current may flow through the first PNP bipolar transistor Qp1 and the first NPN bipolar transistor Qn1. When a positive electrostatic discharge voltage is generated between the first node N1 and the second node N2, an electrostatic discharge current may flow from the first node N1 to the second node N2 through the first diode D1.

The second IO clamp 112b may include a second transistor Mp2, and as described above with reference to FIG. 4, the second transistor Mp2 may be formed by a gate electrode disposed over the channel region. As shown in FIG. 11B, a second capacitor C112 may be connected between the third node N3 and the gate electrode of the second transistor Mp2, and a resistor R110 may be connected between the gate electrode of the second transistor Mp2 and the gate electrode of the first transistor Mp1. When a positive electrostatic discharge voltage is generated between the second node N2 and the third node N3, the second capacitor C112 and the resistor R110 may function as a high pass filter HPF, and accordingly, the second transistor Mp2 may operate like a turned-on PFET. Accordingly, a trigger current may flow from the second node N2 to the third node N3 by sequentially passing through the second transistor Mp2 and the second NPN bipolar transistor Qn2, and then, an electrostatic discharge current may flow through the second PNP bipolar transistor Qp2 and the second NPN bipolar transistor Qn2. When a negative electrostatic discharge voltage is generated between the second node N2 and the third node N3, an electrostatic discharge current may flow from the third node N3 to the second node N2 through the second diode D2.

FIGS. 12A and 12B are diagrams illustrating layouts of a device according to embodiments. For example, FIG. 12A shows top and cross-sectional views of layout 120a of device 110a of FIG. 11A, and FIG. 12B shows top and cross-sectional views of the layout 120b of the device 110b of FIG. 11B. For convenience of illustration, resistors and capacitors are each shown as symbols. In the following descriptions of FIGS. 12A and 12B, descriptions that are the same as those of FIG. 4 will be omitted.

Referring to FIG. 12A, a deep n-well DNW, a second n-well NW2 and a second p-well PW2 may be disposed in the substrate SUB, and a first p-well PW1 and a first n-well NW1 may be disposed in the deep n-well DNW. The first p+ region p1 may surround the first SCR 121 (or deep n-well DNW) and the second SCR 122 on the substrate SUB. The first p+ region p1 may be connected to the third node N3, that is, the cathode of the second SCR 122. The first gate electrode G1 may correspond to the gate electrode of the first transistor Mn1 of FIG. 11A, and the second gate electrode G2 may correspond to the gate electrode of the second transistor Mn2 of FIG. 11A.

The first resistor R121 may be connected between the first node N1 to which the second p+ region p2 and the first n+ region n1 are connected and the first gate electrode G1. The second resistor R122 is connected between the third node N3 to which the first p+ region p1, the fourth n+ region n4, and the fifth p+ region p5 are connected and the second gate electrode G2. Also, the capacitor C120 may be connected between the first gate electrode G1 and the second gate electrode G2. The third p+ region p3, the second n+ region n2, the third n+ region n3, and the fourth p+ region p4 may be connected to the second node N2.

Referring to FIG. 12B, a deep n-well DNW, a second n-well NW2 and a second p-well PW2 may be disposed in the substrate SUB, and a first n-well NW1 and a first p-well PW1 may be disposed in the deep n-well DNW. The first p+ region p1 may surround the first SCR 121 (or deep n-well DNW) and the second SCR 122 on the substrate SUB. The first p+ region p1 may be connected to the third node N3, that is, the cathode of the second SCR 122. The first gate electrode G1 may correspond to the gate electrode of the first transistor Mp1 of FIG. 11B, and the second gate electrode G2 may correspond to the gate electrode of the second transistor Mp2 of FIG. 11B.

The first capacitor C121 may be connected between the first node N1 to which the second p+ region p2 and the first n+ region n1 are connected and the first gate electrode G1. The second capacitor C122 may be connected between the third node N3 to which the first p+ region p1, the fourth n+ region n4, and the fifth p+ region p5 are connected and the second gate electrode G2. Also, the resistor R120 may be connected between the first gate electrode G1 and the second gate electrode G2. The third p+ region p3, the second n+ region n2, the third n+ region n3, and the fourth p+ region p4 may be connected to the second node N2.

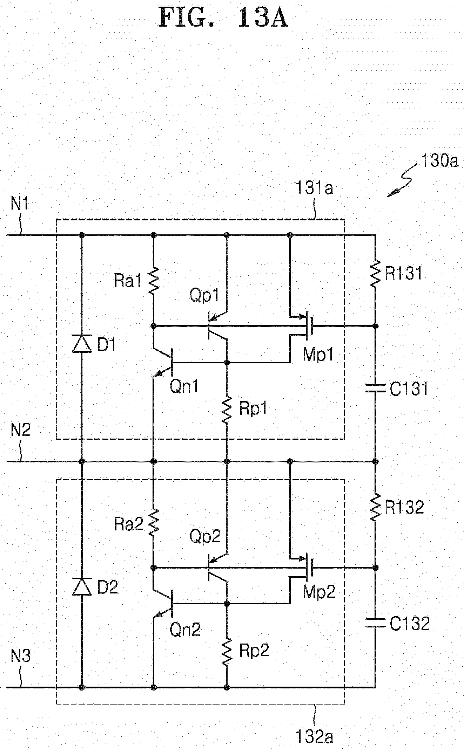

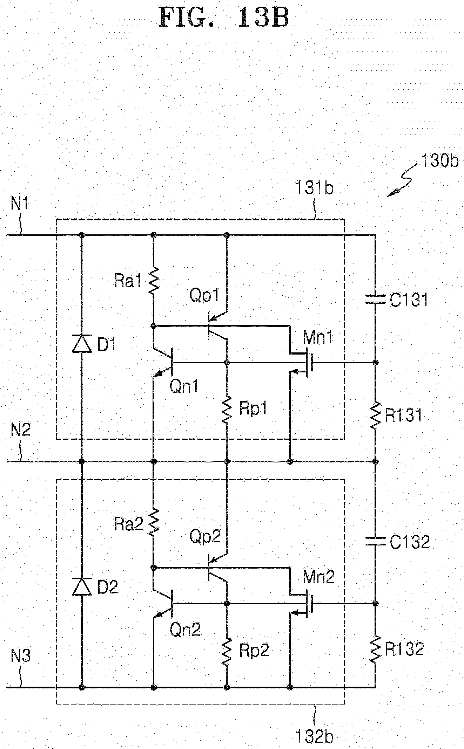

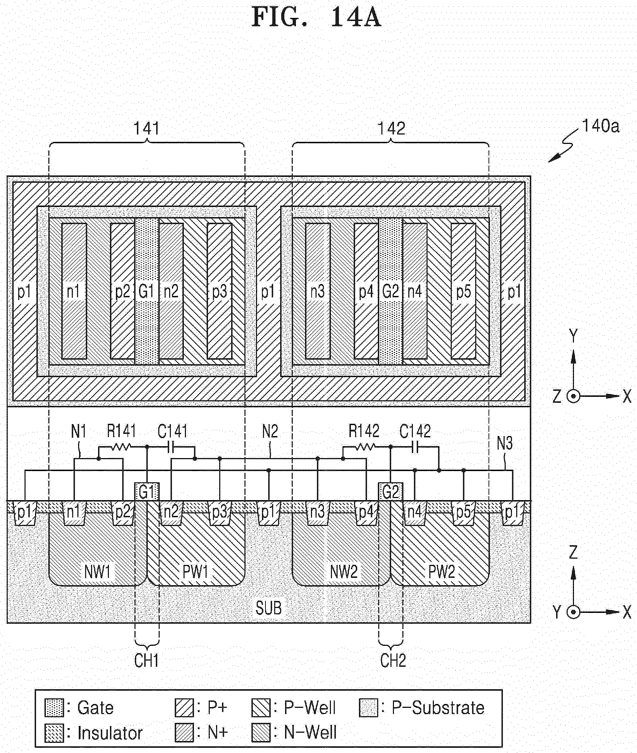

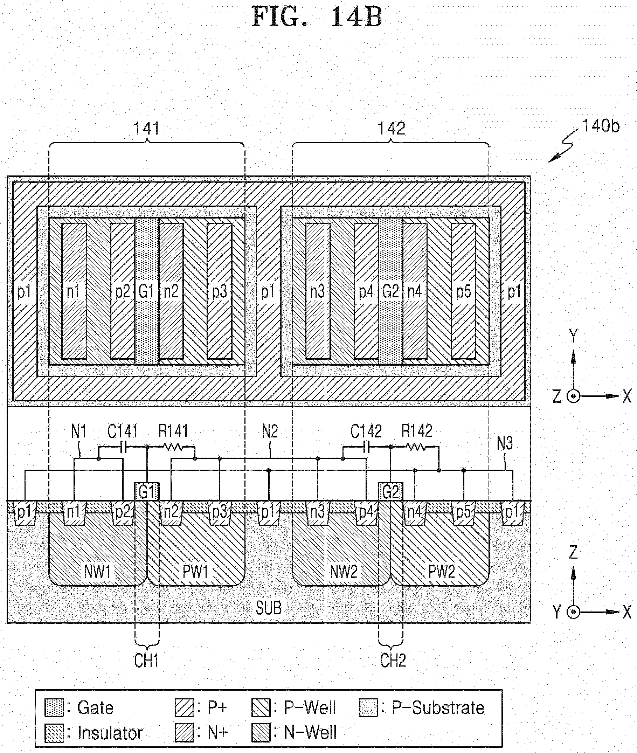

FIGS. 13A and 13B are circuit diagrams illustrating examples of devices according to embodiments. For example, the circuit diagram of FIG. 13A shows an equivalent circuit of a device 130a including a first IO clamp 131a and a second IO clamp 132a, and the circuit diagram of FIG. 13B shows an equivalent circuit of a device 130b including a first IO clamp 131b and a second IO clamp 132b. In the following, descriptions of FIGS. 13A and 13B with reference to the drawings, which are the same as those given above are omitted. FIG. 14A provides an example semiconductor geometry corresponding to the equivalent circuit of FIG. 13A. FIG. 14B provides an example semiconductor geometry corresponding to the equivalent circuit of FIG. 13B.

Referring to FIG. 13A, the first IO clamp 131a may include a first transistor Mp1, and as described above with reference to FIG. 4, the first transistor Mp1 may be formed by a gate electrode disposed over the channel region. As shown in FIG. 13A, a first resistor R131 may be connected between the first node N1 and the gate electrode of the first transistor Mp1, and a first capacitor C131 may be connected between the gate electrode of the first transistor Mp1 and the second node N2. When a positive electrostatic discharge voltage is generated between the first node N1 and the second node N2, the first capacitor C131 and the first resistor R131 may function as a high pass filter HPF, and accordingly, the first transistor Mp1 may operate like a turned-on PFET. Accordingly, a trigger current may flow from the first node N1 to the second node N2 by sequentially passing through the first transistor Mp1 and the first NPN bipolar transistor Qn1, and then, an electrostatic discharge current may flow through the first PNP bipolar transistor Qp1 and the first NPN bipolar transistor Qn1. When a negative electrostatic discharge voltage is generated between the first node N1 and the second node N2, an electrostatic discharge current may flow from the second node N2 to the first node N1 through the first diode D1.

The second IO clamp 132a may include a second transistor Mp2, and as described above with reference to FIG. 4, the second transistor Mp2 may be formed by a gate electrode disposed over the channel region. As shown in FIG. 13A, a second capacitor C132 may be connected between the third node N3 and the gate electrode of the second transistor Mp2, and a second resistor R132 may be connected between the gate electrode of the second transistor Mp2 and the second node N2. When a positive electrostatic discharge voltage is generated between the second node N2 and the third node N3, the second capacitor C132 and the second resistor R132 may function as a high pass filter HPF, and accordingly, the second transistor Mp2 may operate like a turned-on PFET. Accordingly, a trigger current may flow from the second node N2 to the third node N3 by sequentially passing through the second transistor Mp2 and the second NPN bipolar transistor Qn2, and then, an electrostatic discharge current may flow through the second PNP bipolar transistor Qp2 and the second NPN bipolar transistor Qn2. When a negative electrostatic discharge voltage is generated between the second node N2 and the third node N3, an electrostatic discharge current may flow from the third node N3 to the second node N2 through the second diode D2.

Referring to FIG. 13B, the first IO clamp 131b may include a first transistor Mn1, and as described above with reference to FIG. 4, the first transistor Mn1 may be formed by a gate electrode disposed over the channel region. As shown in FIG. 13B, a first capacitor C131 may be connected between the first node N1 and the gate electrode of the first transistor Mn1, and a first resistor R131 may be connected between the gate electrode of the first transistor Mn1 and the second node N2. When a positive electrostatic discharge voltage is generated between the first node N1 and the second node N2, the first capacitor C131 and the first resistor R131 may function as a high pass filter HPF, and accordingly, the first transistor Mn1 may operate like a turned-on NFET. Accordingly, a trigger current may flow from the first node N1 to the second node N2 by sequentially passing through the first PNP bipolar transistor Qp1 and the first transistor Mn1, and then, an electrostatic discharge current may flow through the first PNP bipolar transistor Qp1 and the first NPN bipolar transistor Qn1. When a negative electrostatic discharge voltage is generated between the first node N1 and the second node N2, an electrostatic discharge current may flow from the second node N2 to the first node N1 through the first diode D1.

The second IO clamp 132b may include a second transistor Mn2, and as described above with reference to FIG. 4, the second transistor Mn2 may be formed by a gate electrode disposed over the channel region. As shown in FIG. 13B, a second resistor R132 may be connected between the third node N3 and the gate electrode of the second transistor Mn2, and a second capacitor C132 may be connected between the gate electrode of the second transistor Mn2 and the second node N2. When a positive electrostatic discharge voltage is generated between the second node N2 and the third node N3, the second capacitor C132 and the second resistor R132 may function as a high pass filter HPF, and accordingly, the second transistor Mn2 may operate like a turned-on NFET. Accordingly, a trigger current may flow from the second node N2 to the third node N3 by sequentially passing through the second PNP bipolar transistor Qp2 and the second transistor Mn2, and then, an electrostatic discharge current may flow through the second PNP bipolar transistor Qp2 and the second NPN bipolar transistor Qn2. When a negative electrostatic discharge voltage is generated between the second node N2 and the third node N3, an electrostatic discharge current may flow from the third node N3 to the second node N2 through the second diode D2.

FIGS. 14A and 14B are diagrams illustrating layouts of a device according to embodiments. For example, FIG. 14A shows top and cross-sectional views of layout 140a of device 130a in FIG. 13A, and FIG. 14B shows top and cross-sectional views of layout 140b of device 130b in FIG. 13B. For convenience of illustration, resistors and capacitors are each shown as symbols. In the following descriptions of FIGS. 14A and 14B, descriptions that are the same as those of FIG. 4 will be omitted. FIG. 14A provides an example semiconductor geometry corresponding to the equivalent circuit of FIG. 13A. FIG. 14B provides an example semiconductor geometry corresponding to the equivalent circuit of FIG. 13B.

Referring to FIG. 14A, a first n-well NW1, a first p-well PW1, a second n-well NW2, and a second p-well PW2 may be disposed in the substrate SUB. The first p+ region p1 may surround the first SCR 141 and the second SCR 142 on the substrate SUB. The first p+ region p1 may be connected to the third node N3, that is, the cathode of the second SCR 142. The first gate electrode G1 may correspond to the gate electrode of the first transistor Mp1 of FIG. 13A, and the second gate electrode G2 may correspond to the gate electrode of the second transistor Mp2 of FIG. 13A.

The first resistor R141 may be connected between the first node N1 to which the first n+ region n1 and the second p+ region p2 are connected and the first gate electrode G1. In addition, the first capacitor C141 may be connected between the second node N2 to which the second n+ region n2, the third p+ region p3, the third n+ region n3, and the fourth p+ region p4 are connected and the first gate electrodes G1. The second capacitor C142 may be connected between the third node N3 to which the first p+ region p1, the fourth n+ region n4, and the fifth p+ region p5 are connected and the second gate electrode G2. Also, the second resistor R142 may be connected between the second node N2 and the second gate electrode G2.

Referring to FIG. 14B, a first n-well NW1, a first p-well PW1, a second n-well NW2, and a second p-well PW2 may be disposed in the substrate SUB. The first p+ region p1 may surround the first SCR 141 and the second SCR 142 on the substrate SUB. The first p+ region p1 may be connected to the third node N3, that is, the cathode of the second SCR 142. The first gate electrode G1 may correspond to the gate electrode of the first transistor Mn1 of FIG. 13B, and the second gate electrode G2 may correspond to the gate electrode of the second transistor Mn2 of FIG. 13B.

The first capacitor C141 may be connected between the first node N1 to which the first n+ region n1 and the second p+ region p2 are connected and the first gate electrode G1. In addition, the first resistor R141 may be connected between the second node N2 to which the second n+ region n2, the third p+ region p3, the third n+ region n3, and the fourth p+ region p4 are connected and the first gate electrodes G1. The second resistor R142 is connected between the third node N3 to which the first p+ region p1, the fourth n+ region n4, and the fifth p+ region p5 are connected and the second gate electrode G2. Also, the second capacitor C142 may be connected between the second node N2 and the second gate electrode G2.

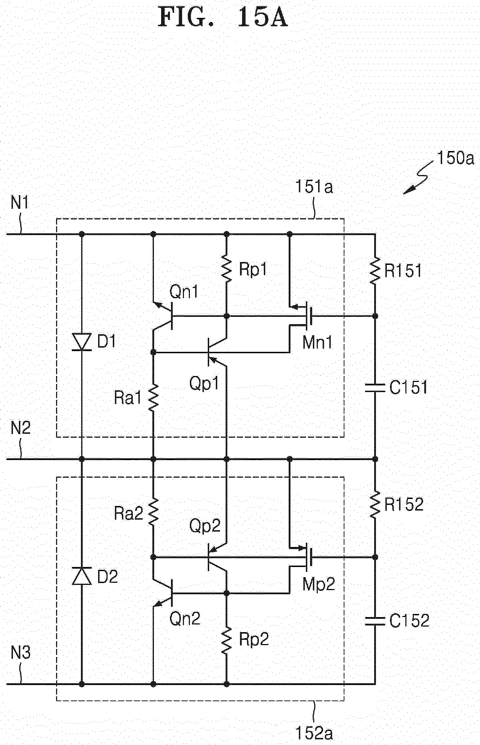

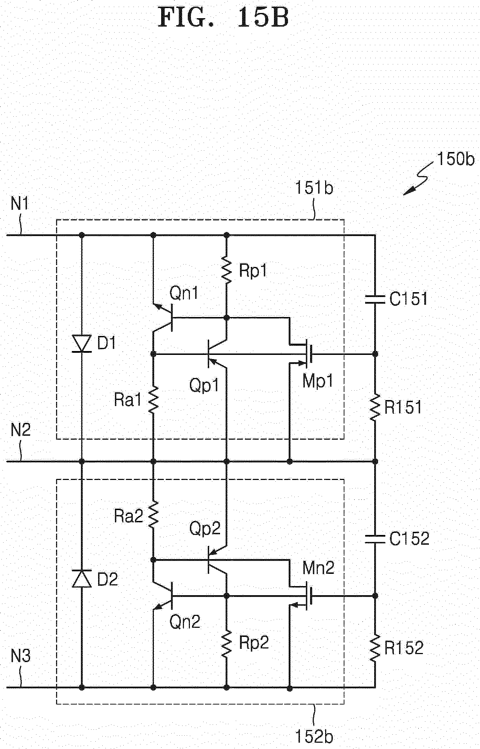

FIGS. 15A and 15B are circuit diagrams illustrating examples of devices according to embodiments. For example, the circuit diagram of FIG. 15A shows an equivalent circuit of a device 150a including a first IO clamp 151a and a second IO clamp 152a, and the circuit diagram of FIG. 15B shows an equivalent circuit of a device 150b including a first IO clamp 151b and a second IO clamp 152b. In the following, descriptions of FIGS. 15A and 15B with reference to the drawings, which are the same as those given above are omitted.

Referring to FIG. 15A, the first IO clamp 151a may include a first transistor Mn1, and as described above with reference to FIG. 4, the first transistor Mn1 may be formed by a gate electrode disposed over the channel region. As shown in FIG. 15A, a first resistor R151 may be connected between the first node N1 and the gate electrode of the first transistor Mn1, and a first capacitor C151 may be connected between the gate electrode of the first transistor Mn1 and the second node N2. When a negative electrostatic discharge voltage is generated between the first node N1 and the second node N2, the first capacitor C151 and the first resistor R151 may function as a high pass filter HPF, and accordingly, the first transistor Mn1 may operate like a turned-on NFET. Accordingly, a trigger current may flow from the second node N2 to the first node N1 by sequentially passing through the first PNP bipolar transistor Qp1 and the first transistor Mn1, and then, an electrostatic discharge current may flow through the first PNP bipolar transistor Qp1 and the first NPN bipolar transistor Qn1. When a positive electrostatic discharge voltage is generated between the first node N1 and the second node N2, an electrostatic discharge current may flow from the first node N1 to the second node N2 through the first diode D1.

The second IO clamp 152a may include a second transistor Mp2, and as described above with reference to FIG. 4, the second transistor Mp2 may be formed by a gate electrode disposed over the channel region. As shown in FIG. 15A, a second capacitor C152 may be connected between the third node N3 and the gate electrode of the second transistor Mp2, and a second resistor R152 may be connected between the gate electrode of the second transistor Mp2 and the second node N2. When a positive electrostatic discharge voltage is generated between the second node N2 and the third node N3, the second capacitor C152 and the second resistor R152 may function as a high pass filter HPF, and accordingly, the second transistor Mp2 may operate like a turned-on PFET. Accordingly, a trigger current may flow from the second node N2 to the third node N3 by sequentially passing through the second transistor Mp2 and the second NPN bipolar transistor Qn2, and then, an electrostatic discharge current may flow through the second PNP bipolar transistor Qp2 and the second NPN bipolar transistor Qn2. When a negative electrostatic discharge voltage is generated between the second node N2 and the third node N3, an electrostatic discharge current may flow from the third node N3 to the second node N2 through the second diode D2.

Referring to FIG. 15B, the first IO clamp 151b may include a first transistor Mp1, and as described above with reference to FIG. 4, the first transistor Mp1 may be formed by a gate electrode disposed over the channel region. As shown in FIG. 15B, a first capacitor C151 may be connected between the first node N1 and the gate electrode of the first transistor Mp1, and a first resistor R151 may be connected between the gate electrode of the first transistor Mp1 and the second node N2. When a negative electrostatic discharge voltage is generated between the first node N1 and the second node N2, the first capacitor C151 and the first resistor R151 may function as a high pass filter HPF, and accordingly, the first transistor Mp1 may operate like a turned-on PFET. Accordingly, a trigger current may flow from the second node N2 to the first node N1 by sequentially passing through the first transistor Mp1 and the first NPN bipolar transistor Qn1, and then, an electrostatic discharge current may flow through the first PNP bipolar transistor Qp1 and the first NPN bipolar transistor Qn1. When a positive electrostatic discharge voltage is generated between the first node N1 and the second node N2, an electrostatic discharge current may flow from the first node N1 to the second node N2 through the first diode D1.

The second IO clamp 152b may include a second transistor Mn2, and as described above with reference to FIG. 4, the second transistor Mn2 may be formed by a gate electrode disposed over the channel region. As shown in FIG. 15B, a second resistor R152 may be connected between the third node N3 and the gate electrode of the second transistor Mn2, and a second capacitor C152 may be connected between the gate electrode of the second transistor Mn2 and the second node N2. When a positive electrostatic discharge voltage is generated between the second node N2 and the third node N3, the second capacitor C152 and the second resistor R152 may function as a high pass filter HPF, and accordingly, the second transistor Mn2 may operate like a turned-on NFET. Accordingly, a trigger current may flow from the second node N2 to the third node N3 by sequentially passing through the second PNP bipolar transistor Qp2 and the second transistor Mn2, and then, an electrostatic discharge current may flow through the second PNP bipolar transistor Qp2 and the second NPN bipolar transistor Qn2. When a negative electrostatic discharge voltage is generated between the second node N2 and the third node N3, an electrostatic discharge current may flow from the third node N3 to the second node N2 through the second diode D2.

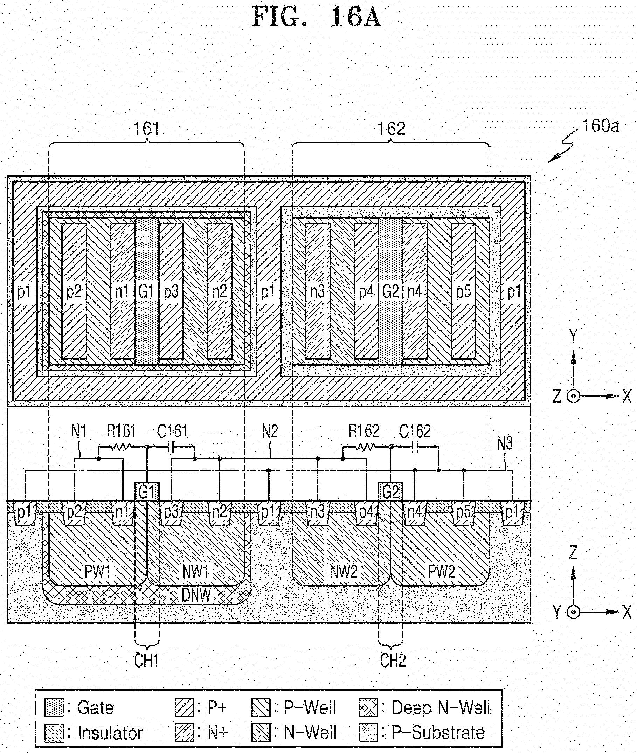

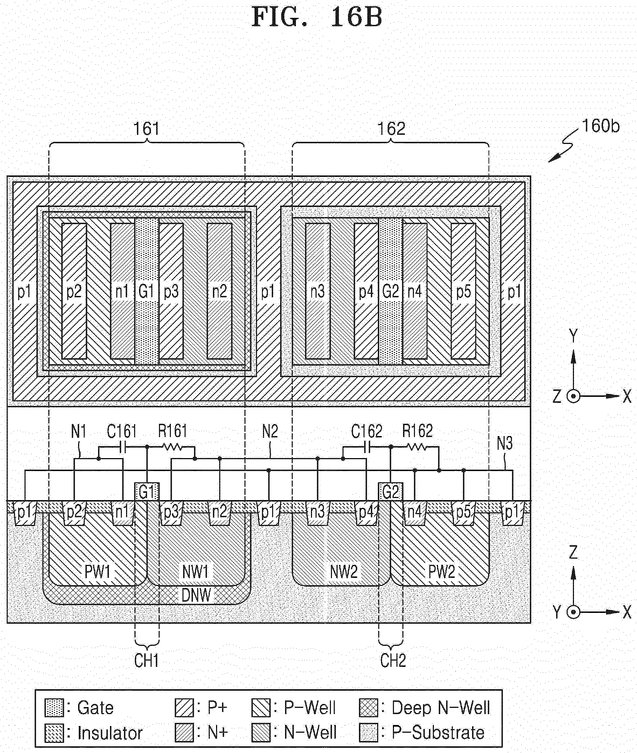

FIGS. 16A and 16B are diagrams illustrating layouts of a device according to embodiments. For example, FIG. 16A shows top and cross-sectional views of layout 160a of device 150a of FIG. 15A, and FIG. 16B shows a plan view and a cross-sectional view of a layout 160b of device 150b of FIG. 15B. For convenience of illustration, resistors and capacitors are each shown as symbols. In the following descriptions of FIGS. 16A and 16B, descriptions that are the same as those of FIG. 4 will be omitted.

Referring to FIG. 16A, a deep n-well DNW, a second n-well NW2 and a second p-well PW2 may be disposed in the substrate SUB, and a first p-well PW1 and a first n-well NW1 may be disposed in the deep n-well DNW. The first p+ region p1 may surround the first SCR 161 (or deep n-well DNW) and the second SCR 162 on the substrate SUB. The first p+ region p1 may be connected to the third node N3, that is, the cathode of the second SCR 162. The first gate electrode G1 may correspond to the gate electrode of the first transistor Mn1 of FIG. 15A, and the second gate electrode G2 may correspond to the gate electrode of the second transistor Mp2 of FIG. 15A.

The first resistor R161 may be connected between the first node N1 to which the second p+ region p2 and the first n+ region n1 are connected and the first gate electrode G1. In addition, the first capacitor C161 is connected between the second node N2 to which the third p+ region p3, the second n+ region n2, the third n+ region n3, and the fourth p+ region p4 are connected and the first gate electrodes G1. The second capacitor C162 may be connected between the third node N3 to which the first p+ region p1, the fourth n+ region n4, and the fifth p+ region p5 are connected and the second gate electrode G2. Also, the second resistor R162 may be connected between the second node N2 and the second gate electrode G2.

Referring to FIG. 16B, a deep n-well DNW, a second n-well NW2 and a second p-well PW2 may be disposed in the substrate SUB, and a first n-well NW1 and a first p-well PW1 may be disposed in the deep n-well DNW. The first p+ region p1 may surround the first SCR 161 (or deep n-well DNW) and the second SCR 162 on the substrate SUB. The first p+ region p1 may be connected to the third node N3, that is, the cathode of the second SCR 162. The first gate electrode G1 may correspond to the gate electrode of the first transistor Mp1 of FIG. 15B, and the second gate electrode G2 may correspond to the gate electrode of the second transistor Mn2 of FIG. 15B.

The first capacitor C161 may be connected between the first node N1 to which the second p+ region p2 and the first n+ region n1 are connected and the first gate electrode G1. In addition, the first resistor R161 may be connected between the second node N2 to which the second n+ region n2, the third p+ region p3, the third n+ region n3, and the fourth p+ region p4 are connected and the first gate electrodes G1. The second resistor R162 is connected between the third node N3 to which the first p+ region p1, the fourth n+ region n4, and the fifth p+ region p5 are connected and the second gate electrode G2. Also, the second capacitor C162 may be connected between the second node N2 and the second gate electrode G2.

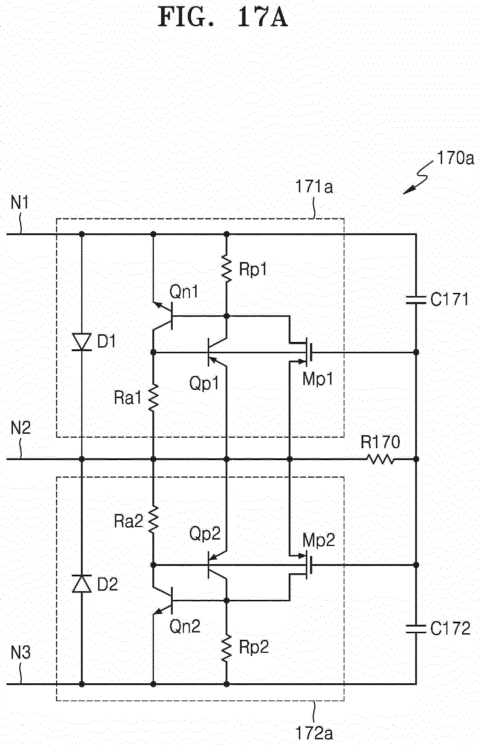

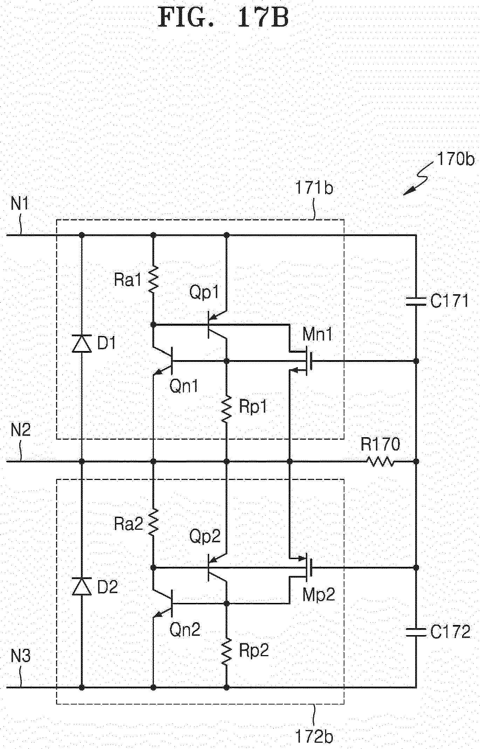

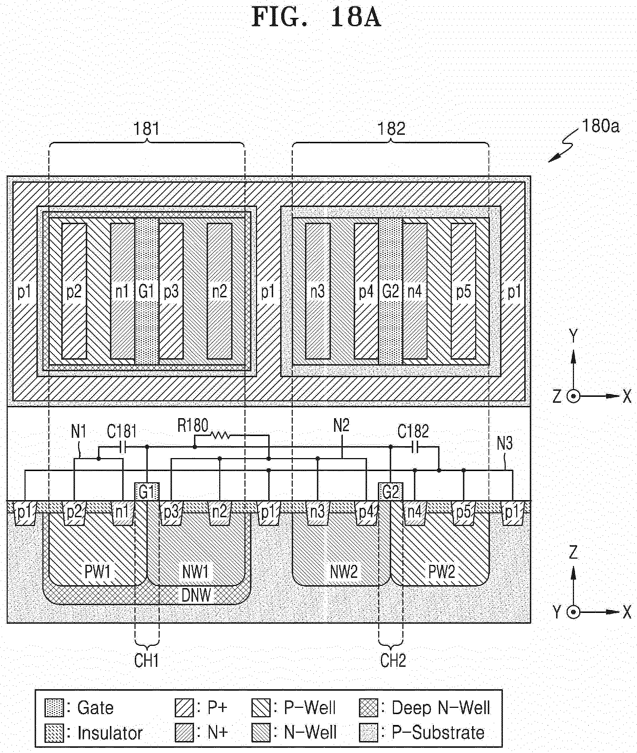

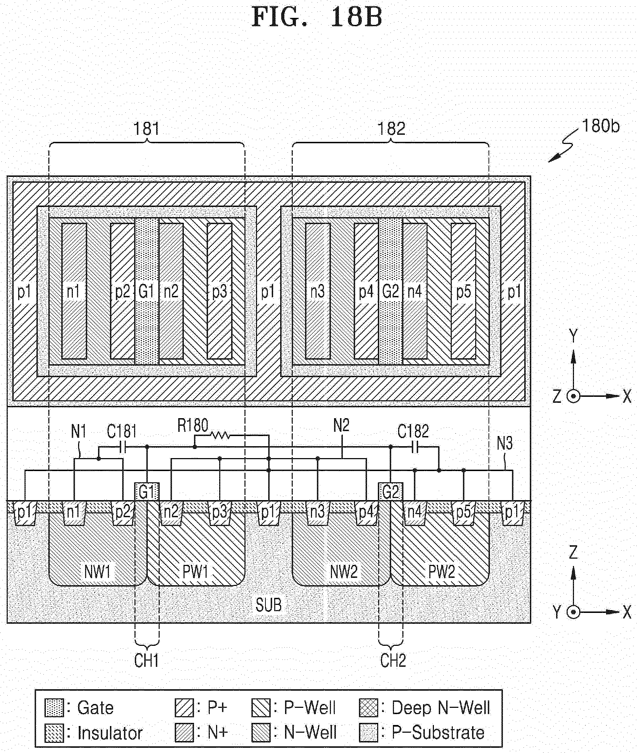

FIGS. 17A and 17B are circuit diagrams illustrating examples of devices according to embodiments. For example, the circuit diagram of FIG. 17A shows an equivalent circuit of a device 170a including a first IO clamp 171a and a second IO clamp 172a, and the circuit diagram of FIG. 17B shows an equivalent circuit of a device 170b including a first IO clamp 171b and a second IO clamp 172b. In the following, descriptions of FIGS. 17A and 17B with reference to the drawings, which are the same as those given above are omitted. FIG. 18A provides an example semiconductor geometry corresponding to the equivalent circuit of FIG. 17A. FIG. 18B provides example semiconductor geometry corresponding to the equivalent circuit of FIG. 17B.

Referring to FIG. 17A, the first IO clamp 171a may include a first transistor Mp1, and as described above with reference to FIG. 4, the first transistor Mp1 may be formed by a gate electrode disposed over the channel region. As shown in FIG. 17A, a first capacitor C171 may be connected between the first node N1 and the gate electrode of the first transistor Mp1, and a resistor R170 may be connected between the gate electrode of the first transistor Mp1 and the second node N2. When a negative electrostatic discharge voltage is generated between the first node N1 and the second node N2, the first capacitor C171 and the resistor R170 may function as a high pass filter HPF, and accordingly, the first transistor Mp1 may operate like a turned-on PFET. Accordingly, a trigger current may flow from the second node N2 to the first node N1 by sequentially passing through the first transistor Mp1 and the first NPN bipolar transistor Qn1, and then, an electrostatic discharge current may flow through the first PNP bipolar transistor Qp1 and the first NPN bipolar transistor Qn1. When a positive electrostatic discharge voltage is generated between the first node N1 and the second node N2, an electrostatic discharge current may flow from the first node N1 to the second node N2 through the first diode D1.

The second IO clamp 172a may include a second transistor Mp2, and as described above with reference to FIG. 4, the second transistor Mn2 may be formed by a gate electrode disposed over the channel region. As shown in FIG. 17A, a second capacitor C172 may be connected between the third node N3 and the gate electrode of the second transistor Mp2, and a resistor R170 may be connected between the gate electrode of the second transistor Mp2 and the second node N2. When a positive electrostatic discharge voltage is generated between the second node N2 and the third node N3, the second capacitor C172 and the resistor R170 may function as a high pass filter HPF, and accordingly, the second transistor Mp2 may operate like a turned-on PFET. Accordingly, a trigger current may flow from the second node N2 to the third node N3 by sequentially passing through the second transistor Mp2 and the second NPN bipolar transistor Qn2, and then, an electrostatic discharge current may flow through the second PNP bipolar transistor Qp2 and the second NPN bipolar transistor Qn2. When a negative electrostatic discharge voltage is generated between the second node N2 and the third node N3, an electrostatic discharge current may flow from the third node N3 to the second node N2 through the second diode D2.

Referring to FIG. 17B, the first IO clamp 171b may include a first transistor Mn1, and as described above with reference to FIG. 4, the first transistor Mn1 may be formed by a gate electrode disposed over the channel region. As shown in FIG. 17B, a first capacitor C171 may be connected between the first node N1 and the gate electrode of the first transistor Mn1, and a resistor R170 may be connected between the gate electrode of the first transistor Mn1 and the second node N2. When a positive electrostatic discharge voltage is generated between the first node N1 and the second node N2, the first capacitor C171 and the resistor R170 may function as a high pass filter HPF, and accordingly, the first transistor Mn1 may operate like a turned-on NFET. Accordingly, a trigger current may flow from the first node N1 to the second node N2 by sequentially passing through the first PNP bipolar transistor Qp1 and the first transistor Mn1, and then, an electrostatic discharge current may flow through the first PNP bipolar transistor Qp1 and the first NPN bipolar transistor Qn1. When a negative electrostatic discharge voltage is generated between the first node N1 and the second node N2, an electrostatic discharge current may flow from the second node N2 to the first node N1 through the first diode D1.

The second IO clamp 172b may include a second transistor Mp2, and as described above with reference to FIG. 4, the second transistor Mp2 may be formed by a gate electrode disposed over the channel region. As shown in FIG. 17B, a second capacitor C172 may be connected between the third node N3 and the gate electrode of the second transistor Mp2, and a resistor R170 may be connected between the gate electrode of the second transistor Mp2 and the second node N2. When a positive electrostatic discharge voltage is generated between the second node N2 and the third node N3, the second capacitor C172 and the resistor R170 may function as a high pass filter HPF, and accordingly, the second transistor Mp2 may operate like a turned-on PFET. Accordingly, a trigger current may flow from the second node N2 to the third node N3 by sequentially passing through the second transistor Mp2 and the second NPN bipolar transistor Qn2, and then, an electrostatic discharge current may flow through the second PNP bipolar transistor Qp2 and the second NPN bipolar transistor Qn2. When a negative electrostatic discharge voltage is generated between the second node N2 and the third node N3, an electrostatic discharge current may flow from the third node N3 to the second node N2 through the second diode D2.

FIGS. 18A and 18B are diagrams illustrating layouts of a device according to embodiments. For example, FIG. 18A shows top and cross-sectional views of layout 180a of device 170a of FIG. 17A, and FIG. 18B shows top and cross-sectional views of the layout 180b of the device 170b of FIG. 17B. For convenience of illustration, resistors and capacitors are each shown as symbols. In the following descriptions of FIGS. 18A and 18B, descriptions that are the same as those of FIG. 4 will be omitted.

Referring to FIG. 18A, a deep n-well DNW, a second n-well NW2 and a second p-well PW2 may be disposed in the substrate SUB, and a first p-well PW1 and a first n-well NW1 may be disposed in the deep n-well DNW. The first p+ region p1 may surround the first SCR 181 (or deep n-well DNW) and the second SCR 182 on the substrate SUB. The first p+ region p1 may be connected to the third node N3, that is, the cathode of the second SCR 182. The first gate electrode G1 may correspond to the gate electrode of the first transistor Mp1 of FIG. 17A, and the second gate electrode G2 may correspond to the gate electrode of the second transistor Mp2 of FIG. 17A.

The first capacitor C181 may be connected between the first node N1 to which the second p+ region p2 and the first n+ region n1 are connected and the first gate electrode G1. The second capacitor C182 may be connected between the third node N3 to which the first p+ region p1, the fourth n+ region n4, and the fifth p+ region p5 are connected and the second gate electrode G2. The resistor R180 may be connected between the second node N2 to which the third p+ region p3, the second n+ region n2, the third n+ region n3, and the fourth p+ region p4 are connected and the first gate electrode G1 (or the second gate electrode G2).

Referring to FIG. 18B, a first n-well NW1, a first p-well PW1, a second n-well NW2, and a second p-well PW2 may be disposed in the substrate SUB. The first p+ region p1 may surround the first SCR 181 and the second SCR 182 on the substrate SUB. The first p+ region p1 may be connected to the third node N3, that is, the cathode of the second SCR 182. The first gate electrode G1 may correspond to the gate electrode of the first transistor Mn1 of FIG. 17B, and the second gate electrode G2 may correspond to the gate electrode of the second transistor Mp2 of FIG. 17B.

The first capacitor C181 may be connected between the first node N1 to which the first n+ region n1 and the second p+ region p2 are connected and the first gate electrode G1. The second capacitor C182 may be connected between the third node N3 to which the first p+ region p1, the fourth n+ region n4, and the fifth p+ region p5 are connected and the second gate electrode G2. Also, the resistor R180 may be connected between the second node N2 to which the second n+ region n2, the third p+ region p3, the third n+ region n3, and fourth p+ region p4 are connected and the first gate electrode G1 (or the second gate electrode G2).

With respect to FIGS. 6A through 18B there is an overall structure. FIG. 6A illustrates R61 from N1 to G1 and C61 from G1 to N2; R61 and C61 form a first R and C pair. Also, C62 is shown from N2 to G2 and R62 is shown from G2 to N3; C62 and R62 form a second R and C pair. FIG. 6B reverses the first R and C pair with respect to G1 and reverses the second R and C pair with respect to G2. FIGS 8A and 8B are similar to FIGS. 6A and 6B with the addition of the deep n-well DNW. FIG. 10 A has some similarity to FIG. 6A, but N2 is not coupled to an R and C pair, rather C 100 spans from G1 to G2. FIG. 10B is similar to FIG. 10A, but the resistor R100 spans from G1 to G2, C101 is connected between N1 and G1 and C102 is connected between G2 and N3. FIG. 12A is similar to FIG. 10A (and respectively FIG. 12B to FIG. 10B), but with the addition of deep n-well DNW. FIG. 14A is similar to FIG. 6A but the second R and C pair is reversed in order with respect to G2. FIG. 14B is similar to FIG. 6A, but the first R and C pair is reversed in order with respect to G1. FIG. 16A is similar to FIG. 14A (and respectively FIG. 16B to FIG. 14B) but with the addition of the deep n-well DNW.

FIG. 18A is a distinct topology with resistor R180 connecting an inter-capacitor node to N2; also, the deep n-well DNW is present. FIG. 18B is like FIG. 18A but without the deep well.

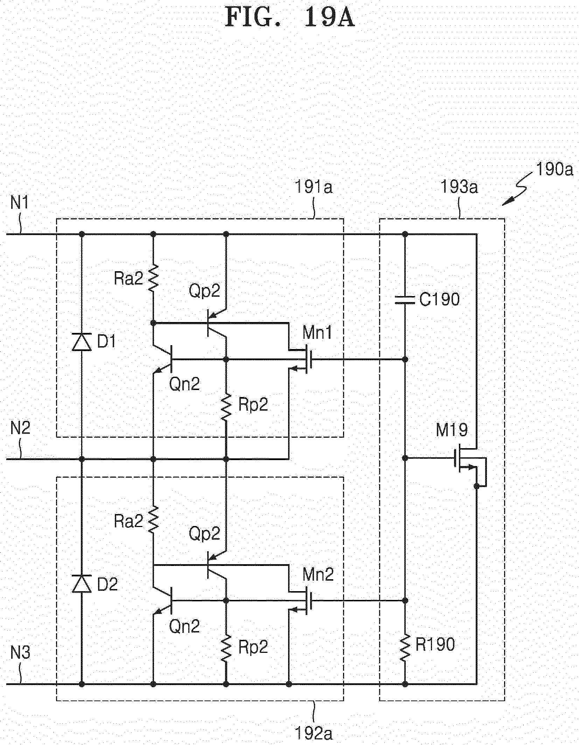

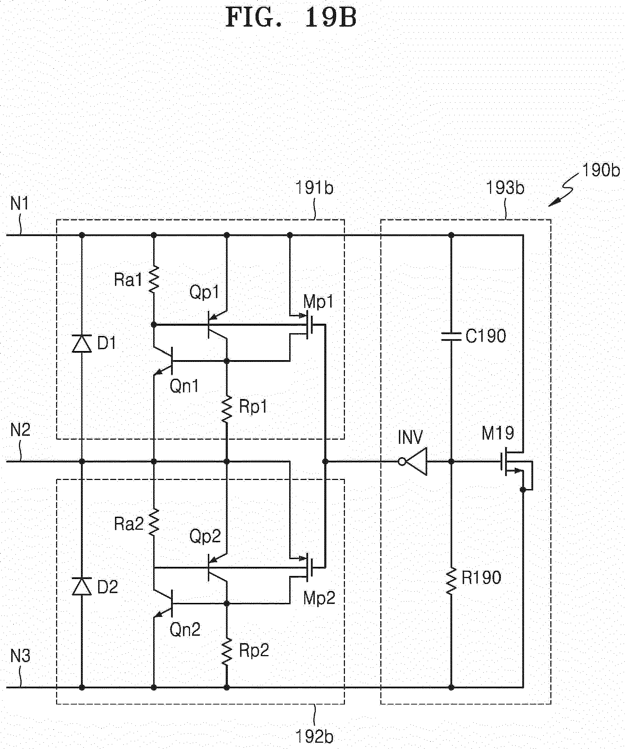

FIGS.19A and 19B are circuit diagrams illustrating examples of devices according to embodiments. For example, the circuit diagram of FIG. 19A shows an equivalent circuit of a device 190a including a first IO clamp 191a, a second IO clamp 192a and a power clamp 193a, and the circuit diagram of FIG. 19B shows an equivalent circuit of a device 190b including a first IO clamp 191b, a second IO clamp 192b, and a power clamp 193b. In the following, descriptions of FIGS. 19A and 19B with reference to the drawings, which are the same as those given above are omitted.

Referring to FIG. 19A, the first IO clamp 191a may include a first transistor Mn1, and the second IO clamp 192a may include a second transistor Mn2. The power clamp 193a may include a transistor M19, a capacitor C190, and a resistor R190. Current terminals of the transistor M19 may be respectively connected to the first node N1 and the third node N3. The capacitor C190 may be connected between the first node N1 and the gate terminal of the transistor M19, and the resistor R190 may be connected between the third node N3 and the gate terminal of the transistor M19. Accordingly, the power clamp 193a may form a low impedance path when a positive electrostatic discharge voltage is generated between the first node N1 and the third node N3. As shown in FIG. 19A, the gate electrode of the first transistor Mn1 and the gate electrode of the second transistor Mn2 may be connected to the gate electrode of the transistor M19. Accordingly, the first transistor Mn1 and the second transistor Mn2 may operate like NFETs in a turn-on state when electrostatic discharge occurs.

Referring to FIG. 19B, the first IO clamp 191b may include a first transistor Mp1, and the second IO clamp 192b may include a second transistor Mp2. The power clamp 193b may include a transistor M19, a capacitor C190, and a resistor R190. Current terminals of the transistor M19 may be respectively connected to the first node N1 and the third node N3. The capacitor C190 may be connected between the first node N1 and the gate terminal of the transistor M19, and the resistor R190 may be connected between the third node N3 and the gate terminal of the transistor M19. Accordingly, the power clamp 193b may form a low impedance path when a positive electrostatic discharge voltage is generated between the first node N1 and the third node N3. As shown in FIG. 19B, the power clamp 193b may further include an inverter INV having an input connected to the gate electrode of the transistor M19, and a gate electrode of the first transistor Mp1 and a gate electrode of the second transistor Mp2 may be connected to an output of the inverter INV. Accordingly, the first transistor Mp1 and the second transistor Mp2 may operate like PFETs in a turned-on state when electrostatic discharge occurs.

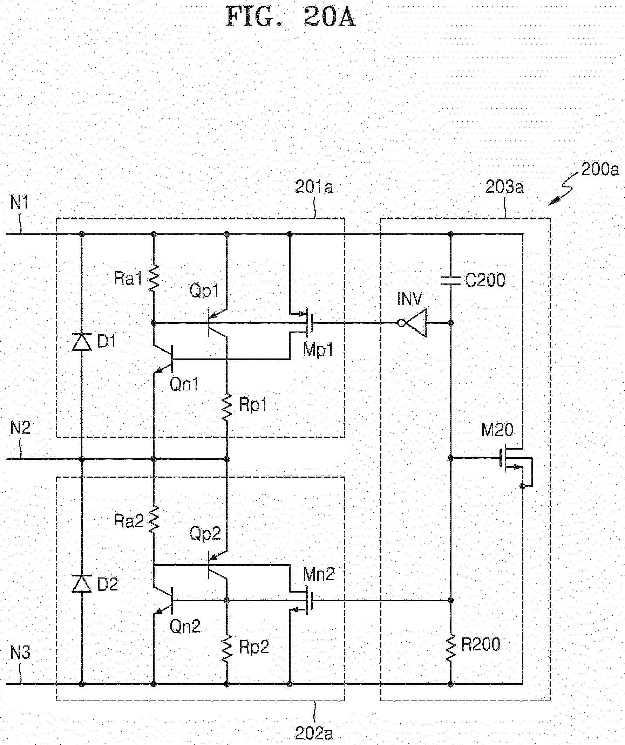

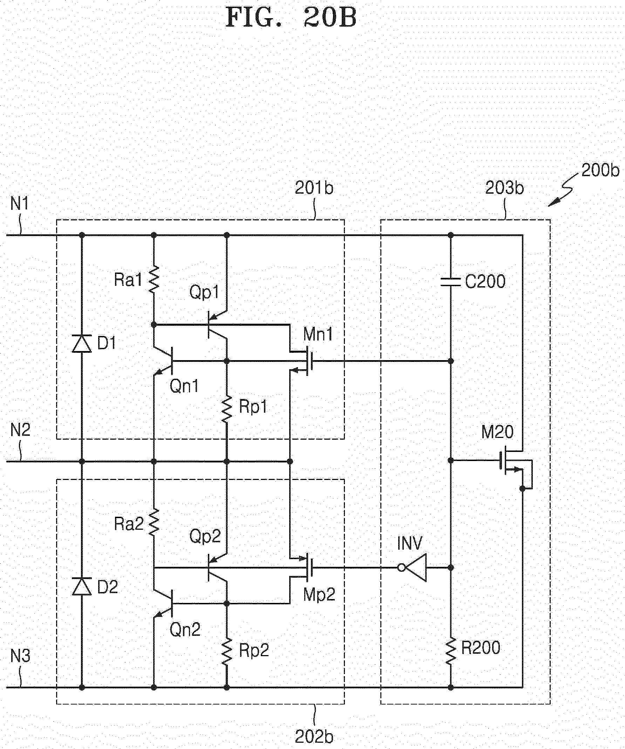

FIGS. 20A and 20B are circuit diagrams illustrating examples of devices according to embodiments. For example, the circuit diagram of FIG. 20A shows an equivalent circuit of a device 200a including a first IO clamp 201a, a second IO clamp 202a and a power clamp 203a, and the circuit diagram of FIG. 20B shows an equivalent circuit of a device 200b including a first IO clamp 201b, a second IO clamp 202b, and a power clamp 203b. In the following, descriptions of FIGS. 20A and 20B with reference to the drawings, which are the same as those given above are omitted.

Referring to FIG. 20A, the first IO clamp 201a may include a first transistor Mp1 and the second IO clamp 202a may include a second transistor Mn2. The power clamp 203a may include a transistor M20, a capacitor C200, and a resistor R200. Current terminals of the transistor M20 may be respectively connected to the first node N1 and the third node N3. The capacitor C200 may be connected between the first node N1 and the gate terminal of the transistor M20, and the resistor R200 may be connected between the third node N3 and the gate terminal of the transistor M20. Accordingly, the power clamp 203a may form a low impedance path when a positive electrostatic discharge voltage is generated between the first node N1 and the third node N3. As shown in FIG. 20A, the power clamp 203a may further include an inverter INV having an input connected to the gate electrode of the transistor M20. A gate electrode of the first transistor Mp1 may be connected to an output of the inverter INV, and a gate electrode of the second transistor Mn2 may be connected to an input of the inverter INV. Accordingly, the first transistor Mp1 may operate like a turned-on PFET when electrostatic discharge occurs, and the second transistor Mn2 may operate like a turned-on NFET when electrostatic discharge occurs.

Referring to FIG. 20B, the first IO clamp 201b may include a first transistor Mn1, and the second IO clamp 202b may include a second transistor Mp2. The power clamp 203b may include a transistor M20, a capacitor C200, and a resistor R200. Current terminals of the transistor M20 may be respectively connected to the first node N1 and the third node N3. The capacitor C200 may be connected between the first node N1 and the gate terminal of the transistor M20, and the resistor R200 may be connected between the third node N3 and the gate terminal of the transistor M20. Accordingly, the power clamp 203b may form a low impedance path when a positive electrostatic discharge voltage is generated between the first node N1 and the third node N3. As shown in FIG. 20B, the power clamp 203b may further include an inverter INV having an input connected to the gate electrode of the transistor M20. A gate electrode of the first transistor Mn1 may be connected to an input of the inverter INV, and a gate electrode of the second transistor Mp2 may be connected to an output of the inverter INV. Accordingly, the first transistor Mn1 may operate like an NFET in a turn-on state when electrostatic discharge occurs, and the second transistor Mp2 may operate like a PFET in a turn-on state when electrostatic discharge occurs.

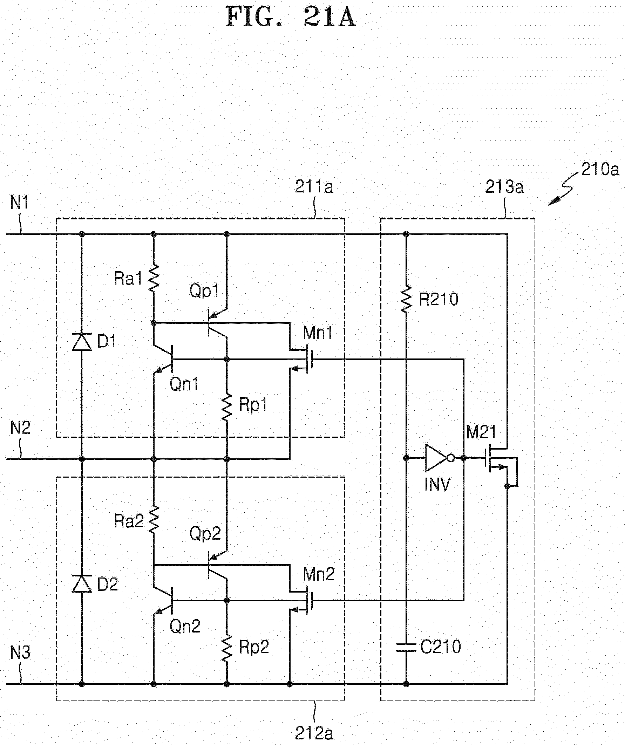

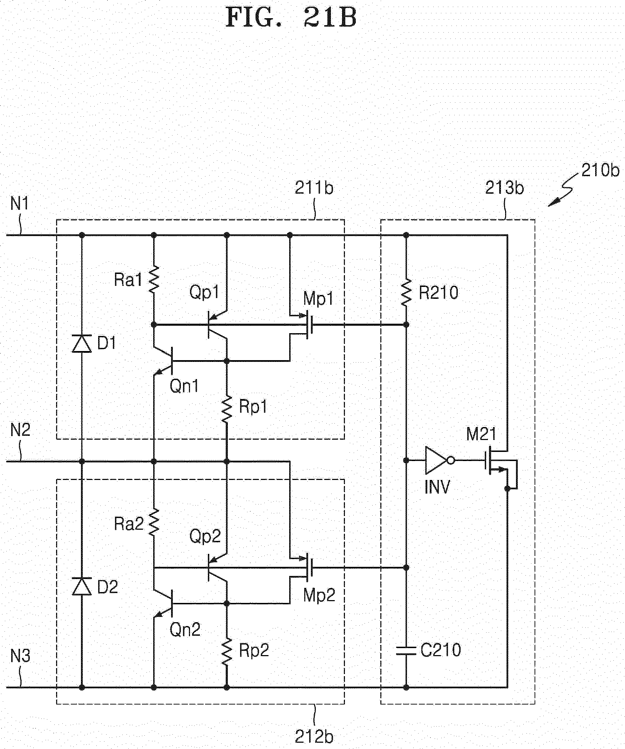

FIGS. 21A and 21B are circuit diagrams illustrating examples of devices according to embodiments. For example, the circuit diagram of FIG. 21A shows an equivalent circuit of a device 210a including a first IO clamp 211a, a second IO clamp 212a and a power clamp 213a, and the circuit diagram of FIG. 21B shows an equivalent circuit of a device 210b including a first IO clamp 211b, a second IO clamp 212b and a power clamp 213b. In the following, descriptions of FIGS. 21A and 21B with reference to the drawings, which are the same as those given above are omitted.

Referring to FIG. 21A, the first IO clamp 211a may include a first transistor Mn1, and the second IO clamp 212a may include a second transistor Mn2. The power clamp 213a may include a transistor M21, a capacitor C210, a resistor R210, and an inverter INV. Current terminals of the transistor M21 may be respectively connected to the first node N1 and the third node N3. A resistor R210 may be connected between the first node N1 and the input of the inverter INV, and a capacitor C210 may be connected between the third node N3 and the input of the inverter INV. The output of the inverter INV may be connected to the gate electrode of the transistor M21, and accordingly, when a positive electrostatic discharge voltage is generated between the first node N1 and the third node N3, the power clamp 213a may form a path of low impedance. As shown in FIG. 21A, the gate electrode of the first transistor Mn1 and the gate electrode of the second transistor Mn2 may be connected to the output of the inverter INV. Accordingly, the first transistor Mn1 and the second transistor Mn2 may operate like NFETs in a turn-on state when electrostatic discharge occurs.

Referring to FIG. 21B, the first IO clamp 211b may include a first transistor Mp1, and the second IO clamp 212b may include a second transistor Mp2. The power clamp 213b may include a transistor M21, a capacitor C210, a resistor R210, and an inverter INV. Current terminals of the transistor M21 may be respectively connected to the first node N1 and the third node N3. A resistor R210 may be connected between the first node N1 and the input of the inverter INV, and a capacitor C210 may be connected between the third node N3 and the input of the inverter INV. The output of the inverter INV may be connected to the gate electrode of the transistor M21, and accordingly, when a positive electrostatic discharge voltage is generated between the first node N1 and the third node N3, the power clamp 213b may form a path of low impedance. As shown in FIG. 21B, the gate electrode of the first transistor Mp1 and the gate electrode of the second transistor Mp2 may be connected to the input of the inverter INV. Accordingly, the first transistor Mp1 and the second transistor Mp2 may operate like PFETs in a turned-on state when electrostatic discharge occurs.

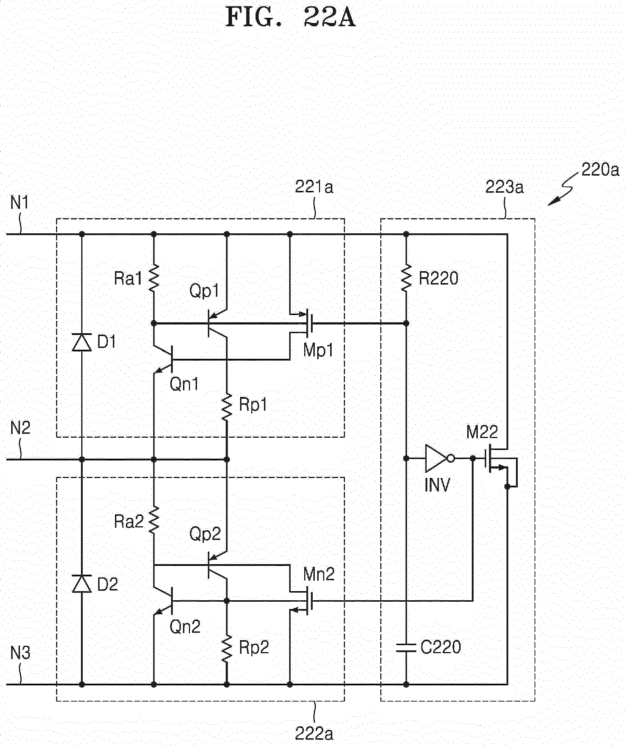

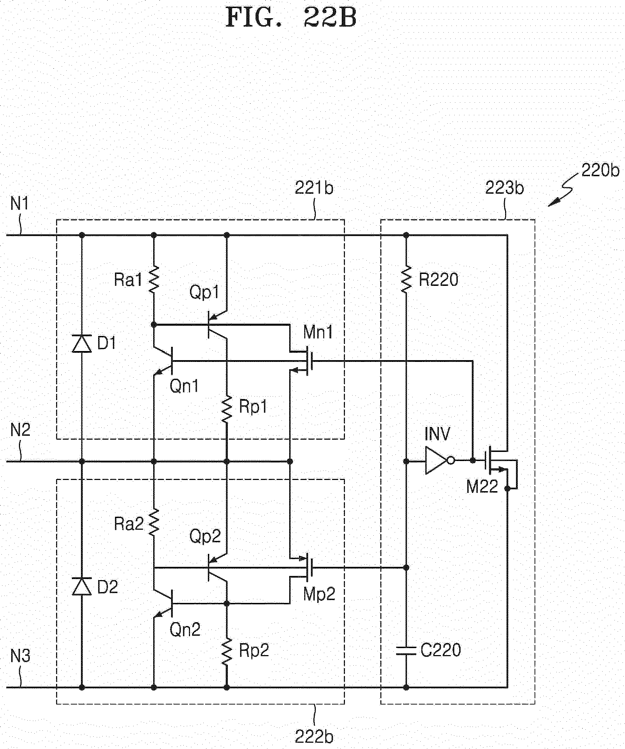

FIGS. 22A and 22B are circuit diagrams illustrating examples of devices according to embodiments. For example, the circuit diagram of FIG. 22A shows an equivalent circuit of a device 220a including a first IO clamp 221a, a second IO clamp 222a and a power clamp 223a, and the circuit diagram of FIG. 22b shows an equivalent circuit of a device 220b including a first IO clamp 221b, a second IO clamp 222b, and a power clamp 223b. In the following, descriptions of FIGS. 22A and 22B with reference to the drawings, which are the same as those given above are omitted.

Referring to FIG. 22A, the first IO clamp 221a may include a first transistor Mp1 and the second IO clamp 222a may include a second transistor Mn2. The power clamp 223a may include a transistor M22, a capacitor C220, a resistor R220, and an inverter INV. Current terminals of the transistor M22 may be respectively connected to the first node N1 and the third node N3. A resistor R220 may be connected between the first node N1 and the input of the inverter INV, and a capacitor C220 may be connected between the third node N3 and the input of the inverter INV. The gate electrode of the transistor M22 may be connected to the output of the inverter INV, and accordingly, when a positive electrostatic discharge voltage is generated between the first node N1 and the third node N3, the power clamp 223a may form a path of low impedance. As shown in FIG. 22A, the gate electrode of the first transistor Mp1 may be connected to the input of the inverter INV, and the gate electrode of the second transistor Mn2 may be connected to the output of the inverter INV. Accordingly, the first transistor Mp1 may operate like a turned-on PFET when electrostatic discharge occurs, and the second transistor Mn2 may operate like a turned-on NFET when electrostatic discharge occurs.

Referring to FIG. 22B, the first IO clamp 221b may include a first transistor Mn1, and the second IO clamp 222b may include a second transistor Mp2. The power clamp 223b may include a transistor M22, a capacitor C220, a resistor R220, and an inverter INV. Current terminals of the transistor M22 may be respectively connected to the first node N1 and the third node N3. A resistor R220 may be connected between the first node N1 and the input of the inverter INV, and a capacitor C220 may be connected between the third node N3 and the input of the inverter INV. The gate electrode of the transistor M22 may be connected to the output of the inverter INV, and accordingly, when a positive electrostatic discharge voltage is generated between the first node N1 and the third node N3, the power clamp 223b may form a path of low impedance. As shown in FIG. 22B , the gate electrode of the first transistor Mn1 may be connected to the output of the inverter INV, and the gate electrode of the second transistor Mp2 may be connected to the input of the inverter INV. Accordingly, the first transistor Mn1 may operate like an NFET in a turn-on state when electrostatic discharge occurs, and the second transistor Mp2 may operate like a PFET in a turn-on state when electrostatic discharge occurs.

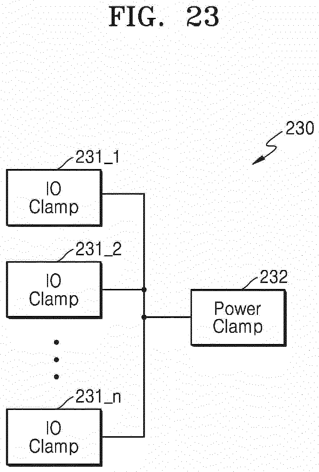

FIG. 23 is a block diagram illustrating a device 230 according to an embodiment. As shown in FIG. 23, the device 230 may include first to n-th IO clamps 231_1 to 231_n and a power clamp 232 (n is an integer greater than 1).

As described above with reference to the drawings, each of the first to n-th IO clamps 231_1 to 231_n may include an SCR and may include a gate electrode for providing a trigger current to the SCR. In some embodiments, gate electrodes of the first to n-th IO clamps 231_1 to 231_n may be connected to the power clamp 232 in common. For example, the gate electrodes included in each of the plurality of IO clamps may be commonly connected to the gate electrode of the transistor M19 of FIG. 19A. For example, the first IO clamp 231_1 may be electrically connected between a first node and a second node, the second IO clamp 231_2 may be electrically connected between the second node and a third node. A gate electrode of the first IO clamp 231_1 and a gate electrode of the second IO claim 231_2 may be electrically connected to the power clamp 232. Accordingly, the use of resistors and capacitors may be reduced, and the efficiency of the device 230 may be further increased.

## Claims

1. A device (10) comprising:
a first clamp circuit (12) electrically connected between a first node (N1) and a second node (N2); and
a second clamp circuit (13) electrically connected between the second node (N2) and a third node (N3),
wherein the first clamp circuit (12) comprises:
a first silicon controlled rectifier, SCR, 41 comprising a first region (n1) of a first conductivity type electrically connected to the first node (N1), a second region (p2) of a second conductivity type electrically connected to the first node (N1), a third region (n2) of the first conductivity type electrically connected to the second node (N2), and a fourth region (p3) of the second conductivity type electrically connected to the second node (N2);
a first n-well (NW1);
a first p-well (PW1); and
a first gate electrode (G1) over a junction of the first n-well (NW1) and the first p-well (PW1) and over a channel region (CH1), wherein the channel region (CH1) comprises a junction of the second region (p2) and the third region (n2) between the first region (n1) and the fourth region (p3), wherein
the first region (n1) and the second region (p2) are disposed in the first n-well (NW1); and
the third region (n2) and the fourth region (p3) are disposed in the first p-well (PW1).

2. The device (10) of claim 1, further comprising:
a first resistor (R51) electrically connected to the first gate electrode (G1); and
a first capacitor (C51) electrically connected to the first gate electrode (G1).

3. The device (10) of claim 2, wherein the second clamp circuit (13) comprises a second SCR (42) and a second gate electrode (G2),
wherein the first resistor (R51) is electrically connected between the first gate electrode (G1) and the first node (N1),
wherein the first capacitor (C51) is electrically connected between the first gate electrode (G1) and the second node (N2), and
wherein the device (10) further comprises:
a second capacitor (C52) electrically connected between the second gate electrode (G2) and the second node (N2); and
a second resistor electrically connected between the second gate electrode (G2) and the third node (N3).

4. The device (10) of claim 2, wherein the second clamp circuit (13) comprises a second SCR (42) and a second gate electrode (G2),
wherein the first resistor (R51) is electrically connected between the first gate electrode (G1) and the first node (N1),
wherein the first capacitor (C51) is electrically connected between the first gate electrode (G1) and the second node (N2), and
wherein the device (10) further comprises:
a second resistor (R52) electrically connected between the second gate electrode (G2) and the second node (N2); and
a second capacitor (C52) electrically connected between the second gate electrode (G2) and the third node (N3).

5. The device (10) of claim 2, wherein the second clamp circuit (13) comprises a second SCR (42) and a second gate electrode (G2),
wherein the first capacitor (C51) is electrically connected between the first gate electrode (G1) and the first node (N1),
wherein the first resistor (R51) is electrically connected between the first gate electrode (G1) and the second node (N2), and
wherein the device (10) further comprises: a second resistor electrically connected between the second gate electrode (G2) and the second node (N2); and
a second capacitor (C52) electrically connected between the second gate electrode (G2) and the third node (N3).

6. The device (10) of claim 2, wherein the second clamp circuit (13) comprises a second SCR (42) and a second gate electrode (G2),
wherein the first resistor (R51) is electrically connected between the first gate electrode (G1) and the first node (N1),
wherein the first capacitor (C110) is electrically connected between the first gate electrode (G1) and the second gate electrode (G2), and
wherein the device (10) further comprises a second resistor electrically connected between the second gate electrode (G2) and the third node (N3).

7. The device (10) of claim 2, wherein the second clamp circuit (13) includes a second SCR (42) and a second gate electrode (G2),
wherein the first capacitor (C91) is electrically connected between the first gate electrode (G1) and the first node (N1),
wherein the first resistor(R90) is electrically connected between the first gate electrode (G1) and the second gate electrode (G2), and
wherein the device (10) further comprises a second capacitor (C92) electrically connected between the second gate electrode (G2) and the third node (N3).

8. The device (10) of claim 2, wherein the second clamp circuit (13) comprises a second SCR (42) and a second gate electrode (G2),
wherein the second gate electrode (G2) is electrically connected to the first gate electrode (G1),
wherein the first capacitor (C51) is electrically connected between the first gate electrode (G1) and the first node (N1),
wherein the first resistor (R51) is electrically connected between the first gate electrode (G1) and the second node (N2), and
wherein the device (10) further comprises a second capacitor (C52) electrically connected between the second gate electrode (G2) and the third node (N3).

9. The device (10) of claim 1, wherein the second clamp circuit (13) comprises a second SCR (42) and a second gate electrode (G2),
wherein the device (10) further comprises a third clamp circuit electrically connected between the first node (N1) and the third node (N3), and
wherein the first gate electrode (G1) and the second gate electrode (G2) are electrically connected to the third clamp circuit.

10. The device (10) of claim 9, wherein the third clamp circuit (193a, 193b) comprises:
A transistor (M19) comprising current terminals electrically connected to the first node (N1) and the third node (N3) respectively;
a capacitor (C190) electrically connected between a control terminal of the transistor (M19) and the first node (N1); and
a resistor (R190) electrically connected between the control terminal of the transistor (M19) and the third node (N3).

11. The device (10) of claim 10, wherein the first gate electrode (G1) and the second gate electrode (G2) are electrically connected to the control terminal of the transistor (M19).

12. The device (10) of claim 10, wherein the third clamp circuit (193b) further comprises an inverter (INV) having an input electrically connected to the control terminal of the transistor (M19), and
wherein the first gate electrode (G1) and the second gate electrode (G2) are electrically connected to an output of the inverter (INV).

13. The device (10) of claim 10, wherein the third clamp circuit (213a) further comprises an inverter (INV) having an input electrically connected to the control electrode of the transistor (M21),
wherein the first gate electrode (G1) is electrically connected to an output of the inverter (INV), and
wherein the second gate electrode (G2) is electrically connected to the control terminal of the transistor (M21).

14. The device (10) of claim 9, wherein the third clamp circuit (213b) comprises:
a transistor (M21) comprising a first current terminal electrically connected to the first node (N1) and a second current terminal electrically connected to the third node (N3);
an inverter (INV) comprising an output electrically connected to a control terminal of the transistor (M21);
a resistor (R210) electrically connected between the first node (N1) and an input of the inverter; and
a capacitor (C210) electrically connected between the third node (N3) and the input of the inverter (INV).

15. The device (10) of claim 9, further comprising:
a fourth clamp circuit electrically connected between the first node (N1) and a fourth node; and
a fifth clamp circuit electrically connected between the fourth node and the third node (N3),
wherein a third gate electrode of the fourth clamp circuit and a fourth gate electrode of the fifth clamp circuit are electrically connected to the third clamp circuit.

## Patentansprüche

1. Eine Vorrichtung (10), umfassend:
eine erste Klemmschaltung (12), die elektrisch zwischen einem ersten Knoten (N1) und einem zweiten Knoten (N2) angeschlossen ist; und
eine zweite Klemmschaltung (13), die elektrisch zwischen dem zweiten Knoten (N2) und einem dritten Knoten (N3) angeschlossen ist,
wobei die erste Klemmschaltung (12) umfasst:
einen ersten siliziumgesteuerten Gleichrichter, SCR, 41, umfassend einen ersten Bereich (n1) eines ersten Leitfähigkeitstyps, der elektrisch mit dem ersten Knoten (N1) verbunden ist, einen zweiten Bereich (p2) eines zweiten Leitfähigkeitstyps, der elektrisch mit dem ersten Knoten (N1) verbunden ist, einen dritten Bereich (n2) des ersten Leitfähigkeitstyps, der elektrisch mit dem zweiten Knoten (N2) verbunden ist, und einen vierten Bereich (p3) eines zweiten Leitfähigkeitstyps, der elektrisch mit dem zweiten Knoten (N2) verbunden ist;
eine erste n-Wanne (NW1);
eine erste p-Wanne (PW1); und
eine erste Gate-Elektrode (G1) über einem Übergang der ersten n-Wanne (NW1) und der ersten p-Wanne (PW1) sowie über einem Kanalbereich (CH1), wobei der Kanalbereich (CH1) einen Übergang des zweiten Bereichs (p2) und des dritten Bereichs (n2) zwischen dem ersten Bereich (n1) und dem vierten Bereich (p3) umfasst, wobei
der erste Bereich (n1) und der zweite Bereich (p2) in der ersten n-Wanne (NW1) angeordnet sind; und
der dritte Bereich (n2) und der vierte Bereich (p3) in der ersten p-Wanne (PW1) angeordnet sind.

2. Die Vorrichtung (10) nach Anspruch 1, ferner umfassend:
einen ersten Widerstand (R51), der elektrisch mit der ersten Gate-Elektrode (G1) verbunden ist; und
einen ersten Kondensator (C51), der elektrisch mit der ersten Gate-Elektrode (G1) verbunden ist.

3. Die Vorrichtung (10) nach Anspruch 2, wobei die zweite Klemmschaltung (13) einen zweiten SCR (42) und eine zweite Gate-Elektrode (G2) umfasst,
wobei der erste Widerstand (R51) elektrisch zwischen der ersten Gate-Elektrode (G1) und dem ersten Knoten (N1) angeschlossen ist,
wobei der erste Kondensator (C51) elektrisch zwischen der ersten Gate-Elektrode (G1) und dem zweiten Knoten (N2) angeschlossen ist, und
wobei die Vorrichtung (10) ferner umfasst:
einen zweiten Kondensator (C52), der elektrisch zwischen der zweiten Gate-Elektrode (G2) und dem zweiten Knoten (N2) angeschlossen ist; und
einen zweiten Widerstand, der elektrisch zwischen der zweiten Gate-Elektrode (G2) und dem dritten Knoten (N3) angeschlossen ist.

4. Die Vorrichtung (10) nach Anspruch 2, wobei die zweite Klemmschaltung (13) einen zweiten SCR (42) und eine zweite Gate-Elektrode (G2) umfasst,
wobei der erste Widerstand (R51) elektrisch zwischen der ersten Gate-Elektrode (G1) und dem ersten Knoten (N1) geschaltet ist,
wobei der erste Kondensator (C51) elektrisch zwischen der ersten Gate-Elektrode (G1) und dem zweiten Knoten (N2) geschaltet ist, und
wobei die Vorrichtung (10) ferner umfasst:
einen zweiten Widerstand (R52), der elektrisch zwischen der zweiten Gate-Elektrode (G2) und dem zweiten Knoten (N2) angeschlossen ist; und
einen zweiten Kondensator (C52), der elektrisch zwischen der zweiten Gate-Elektrode (G2) und dem dritten Knoten (N3) angeschlossen ist.

5. Die Vorrichtung (10) nach Anspruch 2, wobei die zweite Klemmschaltung (13) einen zweiten SCR (42) und eine zweite Gate-Elektrode (G2) umfasst,
wobei der erste Kondensator (C51) elektrisch zwischen der ersten Gate-Elektrode (G1) und dem ersten Knoten (N1) angeschlossen ist,
wobei der erste Widerstand (R51) elektrisch zwischen der ersten Gate-Elektrode (G1) und dem zweiten Knoten (N2) angeschlossen ist, und
wobei die Vorrichtung (10) ferner umfasst: einen zweiten Widerstand, der elektrisch zwischen der zweiten Gate-Elektrode (G2) und dem zweiten Knoten (N2) angeschlossen ist; und
einen zweiten Kondensator (C52), der elektrisch zwischen der zweiten Gate-Elektrode (G2) und dem dritten Knoten (N3) angeschlossen ist.

6. Die Vorrichtung (10) nach Anspruch 2, wobei die zweite Klemmschaltung (13) einen zweiten SCR (42) und eine zweite Gate-Elektrode (G2) umfasst,
wobei der erste Widerstand (R51) elektrisch zwischen der ersten Gate-Elektrode (G1) und dem ersten Knoten (N1) elektrisch verbunden ist,
wobei der erste Kondensator (C110) elektrisch zwischen der ersten Gate-Elektrode (G1) und der zweiten Gate-Elektrode (G2) angeschlossen ist, und
wobei die Vorrichtung (10) ferner einen zweiten Widerstand umfasst, der elektrisch zwischen der zweiten Gate-Elektrode (G2) und dem dritten Knoten (N3) angeschlossen ist.

7. Die Vorrichtung (10) nach Anspruch 2, wobei die zweite Klemmschaltung (13) einen zweiten SCR (42) und eine zweite Gate-Elektrode (G2) umfasst,
wobei der erste Kondensator (C91) elektrisch zwischen der ersten Gate-Elektrode (G1) und dem ersten Knoten (N1) angeschlossen ist,
wobei der erste Widerstand (R90) elektrisch zwischen der ersten Gate-Elektrode (G1) und der zweiten Gate-Elektrode (G2) angeschlossen ist, und
wobei die Vorrichtung (10) ferner einen zweiten Kondensator (C92) umfasst, der elektrisch zwischen der zweiten Gate-Elektrode (G2) und dem dritten Knoten (N3) angeschlossen ist.

8. Die Vorrichtung (10) nach Anspruch 2, wobei die zweite Klemmschaltung (13) einen zweiten SCR (42) und eine zweite Gate-Elektrode (G2) umfasst,
wobei die zweite Gate-Elektrode (G2) elektrisch mit der ersten Gate-Elektrode (G1) verbunden ist,
wobei der erste Kondensator (C51) elektrisch zwischen der ersten Gate-Elektrode (G1) und dem ersten Knoten (N1) elektrisch verbunden ist,
wobei der erste Widerstand (R51) zwischen der ersten Gate-Elektrode (G1) und dem zweiten Knoten (N2) elektrisch angeschlossen ist, und
wobei die Vorrichtung (10) ferner einen zweiten Kondensator (C52) umfasst, der zwischen der zweiten Gate-Elektrode (G2) und dem dritten Knoten (N3) elektrisch angeschlossen ist.

9. Die Vorrichtung (10) nach Anspruch 1, wobei die zweite Klemmschaltung (13) einen zweiten SCR (42) und eine zweite Gate-Elektrode (G2) umfasst,
wobei die Vorrichtung (10) ferner eine dritte Klemmschaltung umfasst, die elektrisch zwischen dem ersten Knoten (N1) und dem dritten Knoten (N3) angeschlossen ist, und
wobei die erste Gate-Elektrode (G1) und die zweite Gate-Elektrode (G2) elektrisch mit der dritten Klemmschaltung verbunden sind.

10. Die Vorrichtung (10) nach Anspruch 9, wobei die dritte Klemmschaltung (193a, 193b) umfasst:
einen Transistor (M19) mit Stromanschlüssen, die elektrisch mit dem ersten Knoten (N1) bzw. dem dritten Knoten (N3) verbunden sind;
einen Kondensator (C190), der elektrisch zwischen einem Steueranschluss des Transistors (M19) und dem ersten Knoten (N1) angeschlossen ist; und
einen Widerstand (R190), der elektrisch zwischen dem Steueranschluss des Transistors (M19) und dem dritten Knoten (N3) angeschlossen ist.

11. Die Vorrichtung (10) nach Anspruch 10, wobei die erste Gate-Elektrode (G1) und die zweite Gate-Elektrode (G2) elektrisch mit dem Steueranschluss des Transistors (M19) verbunden sind.

12. Die Vorrichtung (10) nach Anspruch 10, wobei die dritte Klemmschaltung (193b) ferner einen Inverter (INV) umfasst, dessen Eingang elektrisch mit dem Steueranschluss des Transistors (M19) verbunden ist, und
wobei die erste Gate-Elektrode (G1) und die zweite Gate-Elektrode (G2) elektrisch mit einem Ausgang des Inverters (INV) verbunden sind.

13. Die Vorrichtung (10) nach Anspruch 10, wobei die dritte Klemmschaltung (213a) ferner einen Inverter (INV) umfasst, dessen Eingang elektrisch mit der Steuerelektrode des Transistors (M21) verbunden ist,
wobei die erste Gate-Elektrode (G1) elektrisch mit einem Ausgang des Inverters (INV) verbunden ist, und
wobei die zweite Gate-Elektrode (G2) elektrisch mit dem Steueranschluss des Transistors (M21) verbunden ist.

14. Die Vorrichtung (10) nach Anspruch 9, wobei die dritte Klemmschaltung (213b) umfasst:
einen Transistor (M21) mit einem ersten Stromanschluss, der elektrisch mit dem ersten Knoten (N1) verbunden ist, und einem zweiten Stromanschluss, der elektrisch mit dem dritten Knoten (N3) verbunden ist;
einen Inverter (INV), der einen Ausgang umfasst, der elektrisch mit einem Steueranschluss des Transistors (M21) verbunden ist;
einen Widerstand (R210), der elektrisch zwischen dem ersten Knoten (N1) und einem Eingang des Inverters angeschlossen ist; und
einen Kondensator (C210), der elektrisch zwischen dem dritten Knoten (N3) und dem Eingang des Inverters (INV) angeschlossen ist.

15. Die Vorrichtung (10) nach Anspruch 9, ferner umfassend:
eine vierte Klemmschaltung, die elektrisch zwischen dem ersten Knoten (N1) und einem vierten Knoten angeschlossen ist; und
eine fünfte Klemmschaltung, die elektrisch zwischen dem vierten Knoten und dem dritten Knoten (N3) angeschlossen ist,
wobei eine dritte Gate-Elektrode der vierten Klemmschaltung und eine vierte Gate-Elektrode der fünften Klemmschaltung elektrisch mit der dritten Klemmschaltung verbunden sind.

## Revendications

1. Un dispositif (10) comprenant :
un premier circuit de verrouillage (12) connecté électriquement entre un premier nœud (N1) et un deuxième nœud (N2) ; et
un deuxième circuit de verrouillage (13) connecté électriquement entre le deuxième nœud (N2) et un troisième nœud (N3),
dans lequel le premier circuit de verrouillage (12) comprend :
un premier redresseur commandé au silicium, SCR, 41 comprenant une première région (n1) d'un premier type de conductivité connectée électriquement au premier nœud (N1), une deuxième région (p2) d'un deuxième type de conductivité connectée électriquement au premier nœud (N1), une troisième région (n2) du premier type de conductivité connectée électriquement au deuxième nœud (N2), et une quatrième région (p3) d'un deuxième type de conductivité connectée électriquement au deuxième nœud (N2) ;
un premier puits n (NW1) ;
un premier puits p (PW1) ; et
une première électrode de grille (G1) recouvrant une jonction du premier puits n (NW1) et du premier puits p (PW1) et recouvrant une région de canal (CH1), dans lequel la région de canal (CH1) comprend une jonction de la deuxième région (p2) et de la troisième région (n2) entre la première région (n1) et la quatrième région (p3), dans lequel
la première région (n1) et la deuxième région (p2) sont disposées dans le premier puits n (NW1) ; et
la troisième région (n2) et la quatrième région (p3) sont disposées dans le premier puits p (PW1).

2. Le dispositif (10) selon la revendication 1, comprenant en outre :
une première résistance (R51) reliée électriquement à la première électrode de grille (G1) ; et
un premier condensateur (C51) relié électriquement à la première électrode de grille (G1).

3. Le dispositif (10) selon la revendication 2, dans lequel le deuxième circuit de verrouillage (13) comprend un deuxième SCR (42) et une deuxième électrode de grille (G2),
dans lequel la première résistance (R51) est connectée électriquement entre la première électrode de grille (G1) et le premier nœud (N1),
dans lequel le premier condensateur (C51) est connecté électriquement entre la première électrode de grille (G1) et le deuxième nœud (N2), et
dans lequel le dispositif (10) comprend en outre :
un deuxième condensateur (C52) connecté électriquement entre la deuxième électrode de grille (G2) et le deuxième nœud (N2) ; et
une deuxième résistance connectée électriquement entre la deuxième électrode de grille (G2) et le troisième nœud (N3).

4. Le dispositif (10) selon la revendication 2, dans lequel le deuxième circuit de verrouillage (13) comprend un deuxième SCR (42) et une deuxième électrode de grille (G2),
dans lequel la première résistance (R51) est connectée électriquement entre la première électrode de grille (G1) et le premier nœud (N1),
dans lequel le premier condensateur (C51) est connecté électriquement entre la première électrode de grille (G1) et le deuxième nœud (N2), et
dans lequel le dispositif (10) comprend en outre :
une deuxième résistance (R52) connectée électriquement entre la deuxième électrode de grille (G2) et le deuxième nœud (N2) ; et
un deuxième condensateur (C52) connecté électriquement entre la deuxième électrode de grille (G2) et le troisième nœud (N3).

5. Le dispositif (10) selon la revendication 2, dans lequel le deuxième circuit de verrouillage (13) comprend un deuxième SCR (42) et une deuxième électrode de grille (G2),
dans lequel le premier condensateur (C51) est connecté électriquement entre la première électrode de grille (G1) et le premier nœud (N1),
dans lequel la première résistance (R51) est connectée électriquement entre la première électrode de grille (G1) et le deuxième nœud (N2), et
dans lequel le dispositif (10) comprend en outre : une deuxième résistance connectée électriquement entre la deuxième électrode de grille (G2) et le deuxième nœud (N2) ; et
un deuxième condensateur (C52) connecté électriquement entre la deuxième électrode de grille (G2) et le troisième nœud (N3).

6. Le dispositif (10) selon la revendication 2, dans lequel le deuxième circuit de verrouillage (13) comprend un deuxième SCR (42) et une deuxième électrode de grille (G2),
dans lequel la première résistance (R51) est connectée électriquement entre la première électrode de grille (G1) et le premier nœud (N1),
dans lequel le premier condensateur (C110) est connecté électriquement entre la première électrode de grille (G1) et la deuxième électrode de grille (G2), et
dans lequel le dispositif (10) comprend en outre une deuxième résistance connectée électriquement entre la deuxième électrode de grille (G2) et le troisième nœud (N3).

7. Le dispositif (10) selon la revendication 2, dans lequel le deuxième circuit de verrouillage (13) comprend un deuxième SCR (42) et une deuxième électrode de grille (G2),
dans lequel le premier condensateur (C91) est connecté électriquement entre la première électrode de grille (G1) et le premier nœud (N1),
dans lequel la première résistance (R90) est connectée électriquement entre la première électrode de grille (G1) et la deuxième électrode de grille (G2), et
dans lequel le dispositif (10) comprend en outre un deuxième condensateur (C92) connecté électriquement entre la deuxième électrode de grille (G2) et le troisième nœud (N3).

8. Le dispositif (10) selon la revendication 2, dans lequel le deuxième circuit de verrouillage (13) comprend un deuxième SCR (42) et une deuxième électrode de grille (G2),
dans lequel la deuxième électrode de grille (G2) est reliée électriquement à la première électrode de grille (G1),
dans lequel le premier condensateur (C51) est relié électriquement entre la première électrode de grille (G1) et le premier nœud (N1),
dans lequel la première résistance (R51) est connectée électriquement entre la première électrode de grille (G1) et le deuxième nœud (N2), et
dans lequel le dispositif (10) comprend en outre un deuxième condensateur (C52) connecté électriquement entre la deuxième électrode de grille (G2) et le troisième nœud (N3).

9. Le dispositif (10) selon la revendication 1, dans lequel le deuxième circuit de verrouillage (13) comprend un deuxième SCR (42) et une deuxième électrode de grille (G2),
dans lequel le dispositif (10) comprend en outre un troisième circuit de verrouillage connecté électriquement entre le premier nœud (N1) et le troisième nœud (N3), et
dans lequel la première électrode de grille (G1) et la deuxième électrode de grille (G2) sont connectées électriquement au troisième circuit de verrouillage.

10. Le dispositif (10) selon la revendication 9, dans lequel le troisième circuit de verrouillage (193a, 193b) comprend :
un transistor (M19) comportant des bornes de courant reliées électriquement respectivement au premier nœud (N1) et au troisième nœud (N3) ;
un condensateur (C190) connecté électriquement entre une borne de commande du transistor (M19) et le premier nœud (N1) ; et
une résistance (R190) connectée électriquement entre la borne de commande du transistor (M19) et le troisième nœud (N3).

11. Le dispositif (10) selon la revendication 10, dans lequel la première électrode de grille (G1) et la deuxième électrode de grille (G2) sont connectées électriquement à la borne de commande du transistor (M19).

12. Le dispositif (10) selon la revendication 10, dans lequel le troisième circuit de verrouillage (193b) comprend en outre un inverseur (INV) ayant une entrée connectée électriquement à la borne de commande du transistor (M19), et
dans lequel la première électrode de grille (G1) et la deuxième électrode de grille (G2) sont connectées électriquement à une sortie de l'inverseur (INV).

13. Le dispositif (10) selon la revendication 10, dans lequel le troisième circuit de verrouillage (213a) comprend en outre un inverseur (INV) dont une entrée est reliée électriquement à l'électrode de commande du transistor (M21),
dans lequel la première électrode de grille (G1) est reliée électriquement à une sortie de l'inverseur (INV), et
dans lequel la deuxième électrode de grille (G2) est connectée électriquement à la borne de commande du transistor (M21).

14. Le dispositif (10) selon la revendication 9, dans lequel le troisième circuit de verrouillage (213b) comprend :
un transistor (M21) comprenant une première borne de courant connectée électriquement au premier nœud (N1) et une deuxième borne de courant connectée électriquement au troisième nœud (N3) ;
un inverseur (INV) comprenant une sortie connectée électriquement à une borne de commande du transistor (M21) ;
une résistance (R210) connectée électriquement entre le premier nœud (N1) et une entrée de l'inverseur ; et
un condensateur (C210) connecté électriquement entre le troisième nœud (N3) et l'entrée de l'inverseur (INV).

15. Le dispositif (10) selon la revendication 9, comprenant en outre :
un quatrième circuit de verrouillage connecté électriquement entre le premier nœud (N1) et un quatrième nœud ; et
un cinquième circuit de verrouillage connecté électriquement entre le quatrième nœud et le troisième nœud (N3),
dans lequel une troisième électrode de grille du quatrième circuit de verrouillage et une quatrième électrode de grille du cinquième circuit de verrouillage sont connectées électriquement au troisième circuit de verrouillage.
